(19) Europäisches Patentamt
European Patent Office
Office européen des brevets

(11) Publication number: **0 005 379 B2**

(12) **NEW EUROPEAN PATENT SPECIFICATION**

(45) Date of publication of the new patent specification: **04.06.86**

(51) Int. Cl.$^4$: **G 03 C 1/68,** G 03 C 1/733, G 03 F 7/02

(21) Application number: **79300795.6**

(22) Date of filing: **09.05.79**

(54) **Photosensitive compositions containing carbonylic halides as activators.**

(30) Priority: **09.05.78 US 904144**

(43) Date of publication of application: **14.11.79 Bulletin 79/23**

(45) Publication of the grant of the patent: **04.06.86 Bulletin 86/23**

(45) Mention of the opposition decision: **23.12.81 Bulletin 81/51**

(84) Designated Contracting States: **BE CH DE FR GB NL SE**

(73) Proprietor: **Dynachem Corporation**
**2632 Michelle Drive**
**Tustin California 92680 (US)**

(72) Inventor: **Reardon, Edward Joseph Jr.**
**21795 Meadowview Lane**
**El Toro California 92632 (US)**
Inventor: **Lipson, Melvin A.**
**2829 Altivo Place**
**Fullerton California 92632 (US)**

(74) Representative: **Hose, Cyril Gustav Bidwell et al**
**Baron & Warren 18 South End Kensington**
**London W8 5BU (GB)**

(56) References cited:
**BE-A- 853 935**
**DE-A-1 931 482**
**DE-A-2 049 503**
**DE-A-2 306 353**
**DE-A-2 433 252**
**DE-A-2 718 200**
**DE-A-2 824 928**
**GB-A-1 146 497**
**GB-A-1 269 601**
**GB-A-1 339 316**
**US-A-3 121 632**

(56) References cited:
**US-A-3 501 331**
**US-A-3 514 310**
**US-A-3 767 408**
**US-A-3 769 023**
**US-A-3 929 831**
**US-A-4 007 195**
**US-A-4 065 315**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 005 379 B2**

**Description**

Photosensitive compositions containing carbonylic halides as activators

This invention relates to phototropic photosensitive compositions containing halogen-containing organic compounds which also contain at least one carbonyl group.

Two techniques widely used in the fabrication of printed circuit boards are the additive process and the subtractive process.

In the manufacture of printed circuit boards by the subtractive process, there is adhered to the surface of a copper-clad laminate one surface of a dry, photoresist film; the other surface of the film is adhered to a film support. The photoresist layer is thereafter exposed to light according to a predetermined pattern. The support film is thereafter removed and the copper layer is exposed by washing away the unexposed areas of the photoresist layer. The exposed copper layer is then etched away by chemical milling.

In the additive process, there is adhered to the surface of a substrate (which may or may not be copper-clad) one surface of a dry photoresist film; the other surface is adhered to a film support. The dry photoresist layer is thereafter exposed to a predetermined light pattern and the support film is thereafter removed. The substrate is exposed by washing away the unexposed areas of the photoresist layer. At this point, the substrate is treated with appropriate sensitizers and metalizing solutions, whereby a layer of metal, usually copper, is applied to the substrate.

The dry photoresist films are typically formulated to contrast in color with the substrates with which they are used. Since they generally do not change color, it is extremely difficult to inspect the product after exposure to light but prior to removal of the unexposed areas of the photoresist film to insure that the light mask has been properly placed and to be sure that there are no imperfections or defects in the exposed photopolymerizable layer, it is extremely useful to have a dry photoresist film which visually indicates where the film has been exposed to light so that detection of defects can readily be made prior to developing the film and etching the copper-clad panels or building up a layer of metal on the exposed substrate.

It would also be useful to have a liquid photopolymerizable system that is colorless or lightly colored in the unexposed state and which both crosslinks and becomes intensely colored upon exposure to actinic light.

Prior workers who have worked on phototropic photosensitive compositions have generally used the holgenated methanes and ethanes such as $CBr_4$, $CCl_4$, $CHBr_3$, $CHCl_3$, $CHI_3$ etc. While these materials work in a laboratory context, their volatility makes fabrication of products having a reasonable shelf-life virtually impossible. Further, the toxicity of these materials renders them dangerous to work with.

Work done by Toshio Yamazaki, Harriet J. Cook and Melvin A. Lipson at Dynachem Corporation showed that stable phototropic photosensitive compositions could be obtained using the normally solid amide of a halogenated aliphatic carboxylic acid as an activator for the free base of an amino dyestuff (US-A-4 065 315).

The general preference of the prior art in respect of organic halides used as activators is for there to be more than one halogen atom bound to a single carbon atom; particularly preferred are those compounds having three halogen atoms bound to a single carbon atom. Thus, such compounds as trichloroacetamide and tribromoacetamide are particularly preferred in the prior art.

It has now been found that certain carbonylic halides viz. aliphatic ketones, cycloaliphatic ketones and esters and amides of aliphatic dicarboxylic acids can be advantageously used to formulate stable, phototropic, photosensitive compositions.

According to the present invention there is provided a phototropic, photosensitive composition, such as a film, comprising (a) at least one component which is capable of curing, cross-linking or polymerising upon initiation, such as a compound containing an acrylyl or methacrylyl group or an epoxide-group containing compound, (b) at least one initiator for the component (a) which is potentiated by active radiation, (c) the free base of a dyestuff that forms a halide salt which is more intensely coloured than the free base and (d) a latent activator which releases free halogen radicals when exposed to actinic light and comprises a halogen-containing organic compound, said composition being characterised in that said latent activator comprises a proton donor together with a halogenated aliphatic ketone, a halogenated cycloaliphatic ketone, an ester of a halogenated aliphatic dicarboxylic acid or an amide of a halogenated aliphatic dicarboxylic acid.

The dry photoimagable composition may be in the form of a thin layer and may be a constituent of an assembly comprising a support sheet, said layer of a dry phototropic photosensitive composition, one surface of which is adhered to the support sheet, and a transparent sheet which is adhered to the other surface of said composition.

The phototropic photosensitive composition may be mounted on a support, such as a conductive metal layer, one surface of which may be in contact with a coextensive surface of an insulating layer, or alternatively the support may be non-conductive.

These compositions may also be used as decorative or protective coatings to provide highly colored cured products upon exposure to actinic radiation.

As used herein, the term "phototropic" is intended to identify the capability of a system, such as the

composition referred to above, to darken in response to actinic light; the term is derived from "photo" — indicating light or radiant energy and "tropic" — changing or tending to change in a specified manner in response to a specified stimulus.

As indicated, there is contemplated a photosensitive composition that contains at least one component which is capable of curing, crosslinking or polymerizing upon suitable initiation. In one aspect, this component contains at least one polymerizable ethylenically unsaturated group of structure

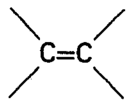

capable of curing, crosslinking or polymerizing under the influence of free radicals. Of these materials, one important class is characterized by the presence of at least one acrylyl or methacrylyl group of formula

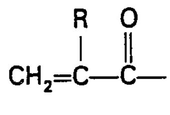

wherer R is hydrogen or methyl. Monomers, polymers, oligomers and compositions whose functionality is attributable to the presence of acrylate and/or methacrylate groups include acrylic acid, methacrylic acid, acrylamide, methacrylamide, methyl acrylate, methyl methacrylate, ethyl acrylate, ethyl methacrylate, hexyl acrylate, cyclohexyl methacrylate, 2-ethylhexyl acrylate, butoxyethoxyethyl acrylate, bicyclo (2.2.1) hept-2-ylacrylate, dicyclopentenyl acrylate, isodecyl acrylate, ethylene diacrylate, diethylene glycol diacrylate, glycerol diacrylate, glycerol triacrylate, ethylene dimethacrylate, ethylene glycol diacrylate, ethylene glycol dimethyacrylate, 1,2,4-butanetriol trimethacrylate, 1,4-benzenediol dimethacrylate, 1,4-cyclohexanediol diacrylate, neopentyl glycol diacrylate, triethylene glycol diacrylate, tetraethyleneglycol diacrylate, pentaerythritol mono-, di-, tri- or tetraacrylate or mixtures thereof, pentaerythritol tri- or tetramethacrylate, 1,5-pentanediol dimethyacrylate, trimethylol propane mono-, di, or triacylate or mixtures thereof, 2-phenoxyethyl acrylate, glycidyl acrylate, 2-ethoxyethyl acrylate, 2-methoxyethyl acrylate, 2-(N,N-diethylamino) ethyl acrylate, omega-methoxyethyl (undecaoxyethylene) acrylate, omega-tridecoxyethyl (undecaoxyethylene) acrylate, trimethoxyallyloxymethyl acrylate, bicyclo (2.2.1) hept-2-en-5-ylmethyl acrylate, bicyclo (2.2.1) hept-2-en-5,6-diyl diacrylate, vinyl acrylate, 2-hydroxypropyl acrylate, 2-hydroxyethyl acrylate, (methyl carbamyl) ethyl acrylate, and the bisacrylates and methacrylate of polyethylene glycols of molecular weight 200—1500.

One group of acrylyl and methacrylyl esters that are particularly useful have the general formula

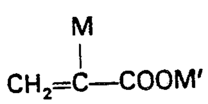

or

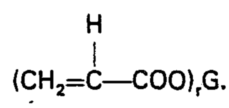

Where the acrylyl compound has the formula

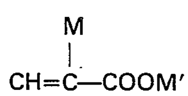

M is H or $CH_3$

M' is cycloalkyl of 5 to 12 carbon atoms (such as cyclopentyl, dicyclopentyl, methylcyclopentyl, dimethylcyclopentyl, etc.)

cycloalkenyl of 5 to 12 carbon atoms (such as cyclopentenyl, methylcyclopentenyl, dicyclopentenyl, bicyclo (2.2.1) hept-2-en-yl, etc.)

$$—C_pH_{2p}M''. \text{ or } (C_qH_{2q}O)_s\ C_qH_2q+1;$$

where

*p* is an integer from 1 to 10

*q* is an integer from 2 to 4

*s* is an integer from 0 to 4

M″ is hydrogen, hydroxyl, phenoxy, alkoxy of 1 to 8 carbon atoms; and where the acrylyl compound has the formula

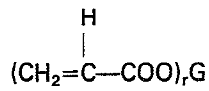

G is a polyvalent alkylene group of formula

$$-C_xH_{2x-y}-$$

in which

*x* is an integer from 2 to 8

*y* is an integer from 0 to 2

(for example, divalent alkylene when y=O such as $-CH_2H_4-$, $C_3H_6$—iso-$C_3H_{66}$—, $-C_5H_{10}$, neo-$C_6H_{12}$ etc. trivalent alkylene when y=1 such as

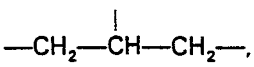, 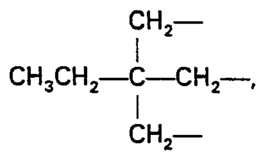, 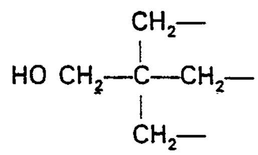

or tetravalent alkylene when y is 2, such as

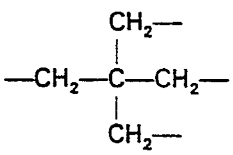 and 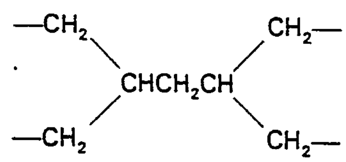

etc.)

or G is a divalent ether or ester group of formula

$$-(C_qH_{2q}O)_t\ C_qH_{2q}- \text{ or } (C_qH_{2q}COO)_t\ C_qH_{2q}-$$

where *t* is an integer from 1 to 5 and *q* is an integer from 2 to 4 (such as oxyethylene, oxypropylene, oxybutylene, polyoxyethylene, polyoxypropylene, polyoxybutylene, etc.) and *r* is the valence of G and can be 2 to 4.

Triethyleneglycol diacrylate, tetraethylene glycol diacrylate, pentaerythritol triacrylate, trimethylolpropane triacrylate and pentaerythritol tetraacrylate are especially useful.

Acrylate or methacrylate functionality can be incorporated in polymers and oligomers having carboxyl, hydroxyl oxirane or isocyanate groups via reaction with acrylic monomers. Addition reactions of isocyanates to form urethanes or oxiranes to form esters are relatively straightforward. Other methods of acrylation involving condensation or ester interchange reactions are well known.

Thus, there can be used epoxy acrylates obtained by reacting an epoxy resin with acrylic or methacrylic acid or obtained by reacting a hydroxyalkyl acrylate with an anhydride and reacting that product with a diepoxide. Oils, such as soybean oil and linseed oil, can be epoxidized and acrylated.

Polyester resins, for example from a glycol-dibasic acid condensation, can be acrylated by using acrylic or methacrylic acid to complete the esterification. Another method uses the reaction of an anhydride with a mixture of propylene oxide and glycidyl acrylate to obtain an acrylated polyester.

Acrylated alkyd resins are obtained by the reaction of, for example, a triol, dibasic acid, phthalic anhydride and a fatty acid such as hydrogenated castor oil. After reaction is complete acrylation is achieved by direct esterification with acrylic acid.

Urethane acrylates can be prepared directly by the reaction of a diisocyanate with an hydroxyalkyl acrylate, such as 2-hydroxyethyl acrylate. Oligomers are obtained by using an isocyanate-terminated urethane prepolymer for reaction with the hydroxyalkyl acrylate. The urethane prepolymer can be of the polyether or polyester type.

Acrylate functionality can be incorporated in a variety of polymer backbones by incorporating glycidyl methacrylate into the polymer chain and then reacting the pendant oxirane groups with acrylic or methacrylic acid.

Other curable systems are based on unsaturated polyesters such as are obtained from fumaric acid, 4,4'-stilbenedicarboxylic acid, maleic acid, and diallyl ether.

Cinnamate ester groups are also useful, for example in a polyvinyl alcohol-cinnamate ester combination and in conjunction with a variety of polymer materials: polycarbonate cinnamate; polyurethane cinnamate; cinnamyl-modified poly (meth) acrylates; polyepichlorohydrin/cinnamate; poly (cinnamyl methacrylate); epoxy cinamylidene acetate; carboxycinnamate modified polyesters.

Curable materials are also obtainable from the 2-phenylmaleimido group; allyl ester-maleimide combinations, althioether polymers, aromatic polysulfone polymer, polysiloxanes, chalcones, sorbic acid derivatives, itaconic acid derivatives and mixtures containing itaconic acid; polyvinyl alcohol, polyvinyl acetate, polyvinyl butyral.

Another polymerizable or curable polymer system is based on the free-radical addition of a thiol to an olefinic double bond:

$$R—SH+CH_2=CHR'\rightarrow R—S—CH_2—CH_2—R'$$

When a polyene and a polythiol are admixed and a stimulus that generates free-radicals is present, rapid curing occurs by simultaneous chain extending and crosslinking reactions.

Other crosslinkable, polymerizable or curable materials include the nitriles such as acrylonitrile and methacrylonitrile; the olefins such as dodecene, styrene, 4-methylstyrene, alphamethylstyrene, cyclopentadiene, dicyclopentadiene, butadiene, 1,4-hexadiene, 4-methyl-1-pentene, bicyclo(2.2.1) hept-2-ene, bicyclo(2.2.1) hept-2,5-diene, cyclohexene; the vinyl halides such as vinyl chloride, vinylidene chloride; the vinyl esters such as vinyl acetate, vinyl butyrate, vinyl benzoate, vinyl butyral, vinyl methacrylate, vinyl crotonate; the vinyl ketones such as vinyl methyl ketone, vinyl phenyl ketone, isopropenyl methyl ketone, divinyl ketone, alpha-chloro-vinyl methyl ketone, vinyl phenyl ketone; acrolein and methacrolein; the vinyl ethers and thioethers such as methyl vinyl ether, ethyl vinyl ether, divinyl ether, isopropyl vinyl ether, the butyl vinyl ethers, 2-ethylhexyl vinyl ether, vinyl 2-chloro-ether, vinyl 2-methoxyethyl ether, n-hexadecyl vinyl ether, vinyl methyl sulfide, vinyl ethylsulfide, divinyl sulfide, 1-chloroethyl vinyl sulfide, vinyl octadecyl sulfide, vinyl 2-ethoxyethyl sulfide, vinyl phenyl sulfide, diallyl sulfide; the miscellaneous sulfur and nitrogen containing monomers such as divinyl sulfone, vinyl ethyl sulfone, vinyl sulfonic acid, vinyl ethyl sulfoxide, sodium vinyl sulfonate, vinyl sulfonamide, vinyl pyridine, N-vinyl pyrrolidone, N-vinyl carbazole. Other curable materials are readily apparent to one skilled in the art of polymerization chemistry. The specific compounds mentioned are illustrative only and not all-inclusive. They can be polymerized alone or in mixtures of two or more thereof with the proportions thereof dependent upon the desire of the individual. They can also be blended with polymers.

The component capable of curing, crosslinking or polymerizing upon suitable initiation can be used alone in mixtures and/or in conjunction with one or more preformed polymers.

Among the polymers that can be used one can include, for example, the polyolefins and modified polyolefins, the vinyl polymers, the polyethers, the polyesters, the polylactones, the polyamides, the polyurethanes, the polyureas, the polysiloxanes, the polysulfides, the polysulfones, the polyformaldehydes, the phenolformaldehyde polymers, the natural and modified natural polymers, the heterocyclic polymers.

The term preformed polymer as used herein includes the homopolymers and copolymers and includes the olefin polymers and copolymers such as polyethylene, poly(ethylene/propylene), poly(ethylene/norbornadiene), poly(ethylene/vinyl acetate), poly(ethylene/vinyl chloride), poly(ethylene/ethyl acrylate), poly(ethylene/acrylonitrile), poly(ethylene/acrylic acid), poly(ethylene/styrene), poly(ethylene/vinyl ethyl ether), poly(ethylene/vinyl methyl ketone), polybutadiene, poly(butadiene/styrene/acrylonitrile), poly(vinylchloride), poly (vinylidene chloride, poly(vinyl acetate), poly(vinyl methyl ether), poly(vinyl butyral), polystyrene, poly(N-vinylcarbazole), poly(acrylic acid), poly(methyl acrylate), poly (ethyl acrylate), polyacrylonitrile, polyacrylamide, poly (methacrylic acid), poly(methyl methacrylate), poly(ethyl methacrylate), poly(N,N-dimethyl acrylamide), poly(methacrylamide), polycaprolactone, poly(caprolactone/vinyl chloride), poly(ethylene glycol terephthalate), poly(caprolactam), poly(ethylene oxide), poly(propylene oxide), copolymers of ethylene oxide and propylene oxide with starters containing reactive hydrogen atoms such as the mixed copolymer using ethylene glycol or glycerol or sucrose, etc., as starter, the natural and modified natural polymers such as gutta percha, cellulose, methyl cellulose, starch, silk, wool, and the siloxane polymers and copolymers, the polysulfides and polysulfones, the formaldehyde polymers such as polyformaldehyde, formaldehyde resins such as phenol-formaldehyde, melamine-formaldehyde, ureaformaldehyde, aniline-formaldehyde and acetone-formaldehyde.

Selection of the preformed polymer will usually depend on the properties desired of the ultimate, cured product.

The materials utilized as curing, crosslinking or polymerization initiators are radiation-sensitive catalyst precursors that are potentiated by radiation to provide an effective initiator species. Ultraviolet light irradiation is the preferred mode of irradiation.

The known photoinitiators include the azo compounds, organic dyes, sulfur containing compounds, metallic salts and complexes, oximes, amines, polynuclear compounds, peroxides, various halogen-containing compounds and organic carbonyl compounds; they can be used alone, in combination with each other or in combination with various synergistic agents.

The aromatic carbonyl compounds are a quite important group of photoinitiators and include benzoin and the benzoin ethers, benzophenone and derivatives of benzophenone, the monoaryl ketones, the diketones, the xanthones, the thioxanthenones, the quinones, and the thioketones.

In the group of benzoin and the benzoin ethers are included such ethers as benzoin methyl ether; benzoin ethyl ether; benzoin allyl ether; benzoin propyl ether; benzoin isopropyl ether; benzoin butyl ether; benzoin isobutyl ether; benzoin sec-butyl ether; benzoin thiophenyl ether; benzoin amyl ether; benzoin hexyl ether; benzoin octyl ether; benzoin 2-ethylhexyl ether; benzoin nonyl ether; benzoin trimethylhexyl ether; benzoin diethyl ether; benzoin phenyl ether; hydroxyethyl benzoin ether; ethylene glycol benzoin ether; 2-chloroethylbenzoin ether; benzoin isobutoxymethyl ether; and α-alkoxybenzoin ethers; benzoin carbamates.

In the group of benzophenone and derivatives of benzophenone are the 4,4'-di(loweralkyl)benzophenones; 4,4'-di(lower alkoxy) benzophenones; 4,4'-diallylbenzophenone; 4,4'-divinylbenzophenone; 4,4'-di(loweracryl)benzophenone; the alkylamino-benzophenones including 4'(dimethylamino) benzophenone; 4-hydroxy-4'-(dimethylamino)benzophenone; 4-hydroxy-4'-(diethylamino)benzophenone; 4-acryloxy-4'-(dimethylamino) benzophenone; 4-methoxy-4'-(dimethylamino)benzophenone;, 4,4'-bis-(diamino)benzophenone; 4,4'-bis-(dimethylamino)benzo-phenone; 4,4'-bis-(diethylamino)benzophenone; and p-dichloromethylbenzophenone; 4-iodobenzophenone; p-chlorobenzophenone; 4,4'-bis (bromomethyl)benzophenone; p-hydroxybenzophenone; 2-hydroxy-4-methoxybenzophenone-5-sulfonic acid; p-acryloxybenzophenone; o-methoxybenzophenone; p-methoxybenzophenone; glycidyl ethers of benzophenone; vinyl-substituted benzophenone; 2-isopropenylbenzophenone; monocarboxyl-substituted benzophenone; polycarboxyl-substituted benzophenone; p-nitrobenzophenone; m-benzophenonesulfonyl chloride; p-p'-bis(dimethylamino) thiobenzophenone; phenylthiomethylbenzophenone; benzylthiomethylbenzophenone; benzopinacolone; anthrone; benzanthrone; benzanthronesulfonyl chloride; 9-fluorenone; hydroxyfluorenones; aminofluorenones; 2-bromoethyl-9-fluorenonesulfonyl chloride; 2-methylfluorenone; 1-propylfluorenone; 2,7-dimethylfluorenone; 2-vinylfluorenone; 2-benzylfluorenone; 2-ethoxyfluorenone; 2,6-dimethoxyfluorenone; 2,4,5-trimethylfluorenone; 2-acetylfluorenone; 2-chlorofluorenone; 2,7-dichlorofluorenone; dibenzosubernone; 1-chloromethyl-6-chlorosulfonyl-2-naphthylphenyl ketone; n-methylacridone; poly(vinyl benzophenone).

The monoaryl ketones include acetophenone, propiophenone, butyrophenone, 3-methylacetophenone, 4-vinylacetophenone, 4-(2-ethylhexyl)-acetophenone, 3-allylacetophenone, 4-vinylacetophenone, 4-hexylpropiophenone, 3-butenylbutyrophenone, 4-tolylacetophenone, 3-benzylacetophenone, 3-xylylacetophenone, 3-methoxyacetophenone, 3-methoxybutyrophenone, 3-decoxyacetophenone, 4-heptoxypropiophenone, 3-bromoacetophenone, 4-chloroacetophenone, 3-chloropropiophenone, 4-iodoacetophenone, 1,4-diacetylbenzene, 1,3-diacetylbenzene, 1,3,4-triacetylbenzene, 1,4-dipropionylbenzene, 1,4-dibutyrobenzene, 3,4-dimethylacetophenone, 1-chloroacetophenone, 1-bromoacetophenone, 1,1'-dichlorobenzophenone, 1-chloroanthraquinone, 1-bromoanthraquinone, 1-chloroxanthane, 1-chlorothioxanthane, 2-chlorothioxanthane, 2,2'-dipyridylketone, 2-benzoylpyridine, 3-benzoylpyridine, 4-benzoylpyridine, 3,4-dihexylacetophenone, 3,4-diethylpropiophenone, 3-methyl-4-methoxyacetophenone, chloroalkylphenyl ketones; α-bromoacetophenone; ortho-bromoacetophenone; trichloroacetophenone; trichloroethylidineacetophenone; 2,2-dichloro-4'-tertiary-butylacetophenone; 2,2,2-trichloro-4'-tertiary-butylacetophenone; α-bromoisobutyrophenone; 2,2-dibromo-2(phenylsulfonyl) acetophenone; α,α-dialkoxyacetophenone; 2,2-dimethoxyacetophenone; 2,2-dimethoxy-2-phenylacetophenone; 2,2-diethoxyacetophenone; o-methoxyacetophenone; m-methoxyacetophenone; p-methoxyacetophenone; 2-butoxy-2-phenylacetophenone; 2-phenylthio-2-phenylacetophenone; ethyl benzoylacetate; para-aminophenyl ketones; cyclohexylphenyl ketone; pivalophenone; valerophenone; and acetonaphthone.

The diketones include biacetyl; benzil dimethyl ketal; 2,3-dibenzoyl-2-norbornene; benzoylbenzal chloride; 2,2-dibromo-2-(phenylsulfonyl) propanedione; a-naphthil; 2,3-butanedione; benzil; pentanedione; 1-aryl-1,2-propanediones; 2,3-bornanedione; phenylpyruvic acid; 2,4-pentanedione.

The xanthones and thioxanthenones include xanthone, 2-methylxanthone, 3-pentylxanthone, 2,6-diethylxanthone, 2-tolyxanthone, 2-methoxyxanthone, 4-methoxyxanthone, 2-acetylxanthone, 2,7-diacetylxanthone, 3-chloroxanthone, 4-bromoxanthone, 2-chloroxanthone, 2,7-dichloroxanthone, 2-chloro-6-nonylxanthone, 2-iodo-5-methoxyxanthone, thioxanthenone; 2-methylthioxanthenone; 3,6-bis(dimethylamino) thioxanthenone; 2-chlorothioxanthenone.

The quinones include p-benzoquinone; o-benzoquinonediazide; anthraquinone; alkylanthraquinones; 2-methylanthraquinone; 2-ethylanthraquinone; 2-tertiary-butylanthraquinone; 2,6-dimethylanthraquinone; 1,5-diethylanthraquinone; 2-vinyllanthraquinone; 2-xylylanthraquinone; 2,6-dimethoxyanthraquinone; 2,7-diethoxyanthraquinone; 2-acetylanthraquinone; 2-chloroanthraquinone; 2,4,8-trichloroanthraquinone; 2-bromoanthraquinone; aminoanthraquinone; 1,5-diaminoanthraquinone; piperidinoanthraquinones; anthraquinonesulfonyl chloride; benzanthraquinone; 1,4-napthoquinone derivatives; phenanthrenequinones; a-chloroanthraquinone.

The thioketones include thiobenzophenone; p,p'-dimethoxythiobenzophenone; p,p'-bis(dimethylamino) thiobenzophenone.

The azo compounds that are useful include azo compounds, azido compounds and diazonium salts. Azo and azido compounds include 2,2'-azobisisopropane; azobisisobutyronitrile; 2-phenylazobisisobutyronitrile; azobisisobutyramide; azobis (isobutyl acetate); di-(2,4,6-tribromophenyl)-4,4'-azobis (4-cyano-

valerate); p-azidobenzaldehyde; b-naphthalenesulfonyl azide; diazomethane; bis(phenylsulfonyl) diazomethane; diazonaphthalenes; diazothioethers; quinone diazides, m,m'-azoxystyrene.

The sulfur containing compounds include n-dodecyl mercaptan; 2-mercaptobenzimidiazole; diphenyl sulfide; cyclohexylphenylsufide; benzoin thioethers; benzoin thiophenyl ether; phenylthiomethylbenzophenone; s,s'-diphenyl dithiocarbonate; calcium sulfide; metallic, tellurides; diaryl disulfides; diphenyl disulfide; dithiolane; dibenzoyldisulfide; dixanthate; benzothiazoles; 2,2'-dithiobis-(benzothiazole); 2-mercaptobenzothiazole; thiazolines; thiocarbamates; dithiocarbamic esters; dithiocarbamic anhydrides; thiurams; toluene sulfonic acid; sulfonyl chlorides; m-(chlorosulfonyl)benzyl chloride; naphthalenesulfonyl chloride; 2-bromoethyl-9-fluorenonesulfonyl chloride; 2,2-dibromo-2(phenylsulfonyl)acetophenone; 2,2-dibromo-2(phenylsulfonyl) propanedione; benzophenonesulfonylchloride; diphenyl disulfone.

The oximes include o-acyloximes; 1-phenyl-1, 2-propanedione-2-o-benzoyl oxime; oxido-oxazole; benzylmonooxime.

The polynuclear compounds include napththalene; halogenated naphthalenes; 2,3,6-trimethylnaphthalene; a-naphthol; 1-aminonaphthalene; 1-methoxynaphthalene; 2,3-diphenylquinoxaline; anthracene; aminoanthraquinone; phenanthrene; naphthacene; fluorene; 9-fluorenone; stilbene; trinitrofluorenone; polynuclear quinones.

The metal salts and complexes include zinc chloride; zinc bromode; zinc sulfide; ferric chloride; chromium chloride; nickel chloride; tin chloride; stannous chloride; vanadium tetrachloride; vanadium oxychloride; vanadium naphthenate, aluminum chloride; aluminum bromide; aluminum iodide; silver halides; gold salts; sodium chloraurate; mercury salts; mercury iodosulfide; titanium tetrachloride; cadmium sulfide; boron trifluoride; boron trichloride; ceric salts; thallium salts; uranyl salts; cobalt octoate; cobalt naphthenate; magnesium oxide; zinc oxide; titanium dioxide; alumina; cupric oxide; chromium oxide; silver oxide compounds; metal chelates; metal amine complexes; cobalt EDTA complexes; iron EDTA complexes; metal acetylacetonate; manganese tris (acetylacetonate); metal salt-saccharide complexes; metal oxalato complexes; p-benzoquinone complexes; copper (1) complexes; manganese carbonyl; rhenium carbonyl; osmium carbonyl; iron carbonyls; metal thiocarbonyls; trialkylaluminum; diethylaluminum chloride; triphenylmethyldiethyltitanium chloride; bis(2-chloroethyl) diethyltitanium; tetrabenzyltitanium, ferrocene; cyclopentadienylmanganese tricarbonyls.

The peroxides include hydrogen peroxide; benzoyl peroxide; tertiary-butyl peroctoate; t-butyl a-cyanoperacetate; t-butyl hydroperoxide; di-t-butyl peroxide; cumene hydroperoxide; a-cumyl peroxide; ergosterol peroxide; fluorenone hydroperoxide; acetyl peroxide.

The imidazoles include benzimidazoles; 2-methylbenzimidazole; 2-mercaptobenzimidazole; triphenylimidazolyl dimers.

Ammonium salts include bipyridylium salt; benzyltrimethylammonium chloride.

Organic dyes that are useful include acridines; benzacridine; benzidines; b-carotene; chlorophyll; crystal violet; eosin; erythrosine; fluorescein; indanthrene yellow; irgazin yellow; methyl violet; methylene blue; pyronone-G; rhodamines; riboflavin; rose bengal; thiazine dyes; thionine; xanthene dyes; xanthophyll; iodoeosine.

Where the component capable of curing, crosslinking or polymerization contains an ethylenically unsaturated group, and notably an acrylyl or methacrylyl group, the preferred free radical photoinitiators are the benzoin ethers, benzophenone, the alkylamino benzophenones, the xanthones, the thioxanthones as well as combinations of said photoinitiators with each other and with chain transfer agents such as organic amines.

As colorformer, there can, in one aspect, be used the free base of:

(a) an amino derivative of a triarylmethane dye
(b) an amino derivative of a xanthene dye
(c) an amino derivative of an acridine dye
(d) a methine or polymethine dye

As ketone imine dyestuffs, there can be used the free bases of Auramine O and Auramine G, C.I. 4000B and 41005.

The amino triarylmethane dyestuffs whose free bases can be used, can be generally represented by the formula

$$\left[ Ar_1 - \underset{\underset{Ar_3}{|}}{C} = Ar_2 \right]^+ \quad OH^-$$

Where $Ar_1$, $Ar_2$ and $Ar_3$ are carbocyclic aryl groups that are unsubstituted or substituted by one to three of:

lower alkyl, lower alkoxy, lower acyl, carboxyl, carboloweralkoxy, sulfo, including the alkali, alkaline earth metal and ammonium salts thereof, nitro, halo, hydroxyl and amino of formula

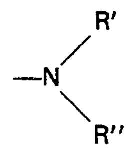

where R′ and R″ each independently is hydrogen, lower alkyl, phenyloweralkylene, phenyl, sulfoloweralkylene, lower acyl, naphthyl, and where said phenyl and naphthyl groups are optionally substituted by one to three of nitro, sulfo, hydroxyl, lower alkoxy, lower alkyl, amino, sulfamyl, carboxyl, carbamyl, phenylimino and halogen and provided that at least one of $Ar_1$, $Ar_2$ and $Ar_3$ contain at least one amino group of formula

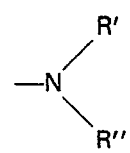

and where $Ar_3$ can additionally be indolyl that is optionally substituted.

The triarylmethane dyes whose free bases are of particular interest herein can be more specifically represented by the following formula:

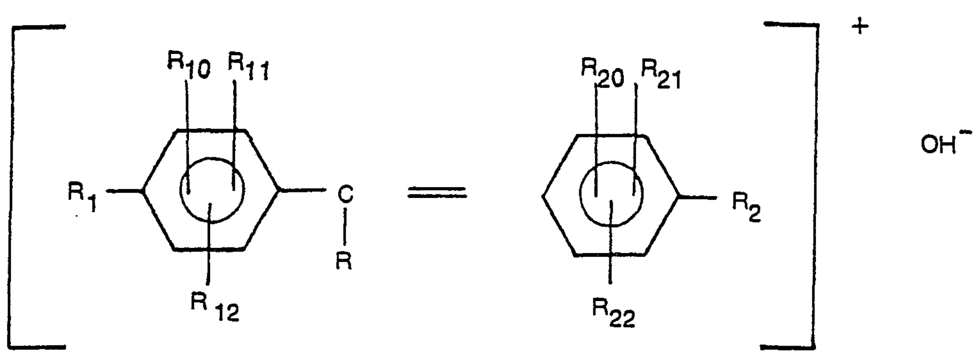

where R is carbocyclic or heterocyclic aryl of formula

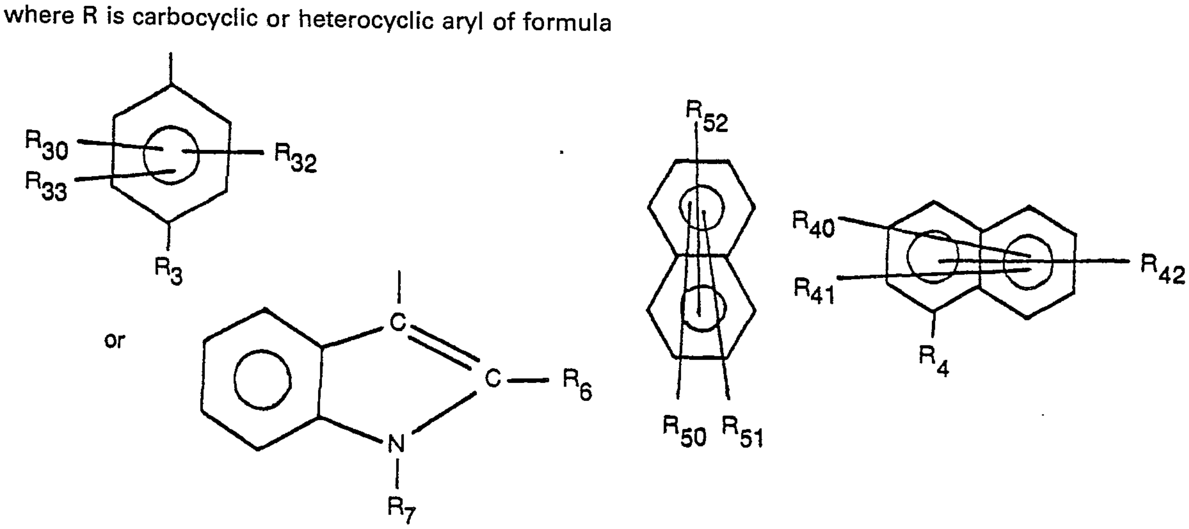

or

where $R_1$, $R_2$, $R_3$ and $R_4$ each independently is hydrogen, hydroxyl, or amino of formula

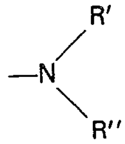

where R′ and R″ each independently is hydrogen, lower alkyl, lower acyl, sulfoloweralkylene, phenylloweralkylene, phenyl or naphthyl, said phenyl or said naphthyl groups being unsubstituted or substituted by one to three of nitro, sulfo, hydroxyl, lower alkoxy, lower alkyl, amino, sulfamyl, carbamyl, carboxyl, lower acyl, carboloweralkoxy, halogen or phenylimino where said phenyl group may be substituted as described; and where at least one of $R_1$, $R_2$, $R_3$ and $R_4$ is amino of formula

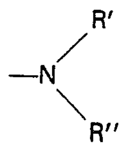

and $R_{10}$, $R_{11}$, $R_{12}$, $R_{20}$, $R_{21}$, $R_{22}$, $R_{30}$, $R_{31}$, $R_{32}$, $R_{40}$, $R_{41}$, $R_{42}$, $R_{50}$, $R_{51}$ and $R_{52}$, each independently is hydrogen, lower alkyl, hydroxyl, carboxyl, sulfo including the ammonium, alkali or alkaline earth metal salt thereof, nitro, halo, phenylazo, loweralkoxy, lower acyl, carboloweralkoxy, or amino of formula

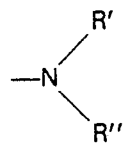

where R′ and R″ are as previously defined and $R_6$ is lower alkyl or phenyl and $R_7$ is hydrogen or lower alkyl.

The free bases of triarylmethane dyestuffs of the following formula are a preferred class of dyes

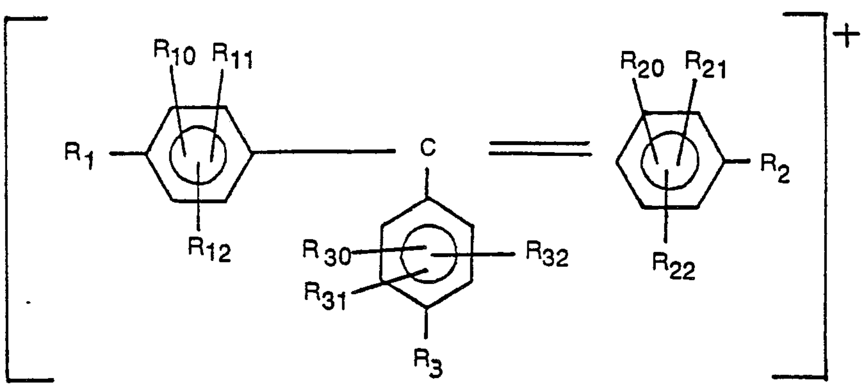

where the substituents are all as previously defined.

Within the family of dyes described by the formula immediately preceding, preferred are those where $R_1$, $R_2$ and $R_3$ are hydrogen or

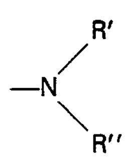

where R′ and R″ each independently is hydrogen, alkyl of one to four carbonatoms, benzyl, phenyl, sulfoethylene and where said phenyl and benzyl are unsubstituted or substituted in the aromatic moiety by one to three of nitro, sulfo, hydroxyl, alkyl of one to four carbonatoms, alkoxy of one to four carbonatoms, amino or chloro.

Of the dyes set out immediately above, particularly preferred are those where $R_1$ and $R_2$ are

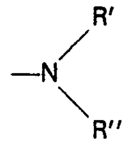

and $R_3$ is hydrogen, sodium sulfo or

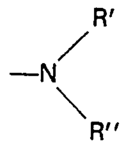

and where R' and R'' each is hydrogen, methyl, ethyl, phenyl or sodium sulfo phenyl.

Especially preferred are the free bases of the dyestuffs having the formula

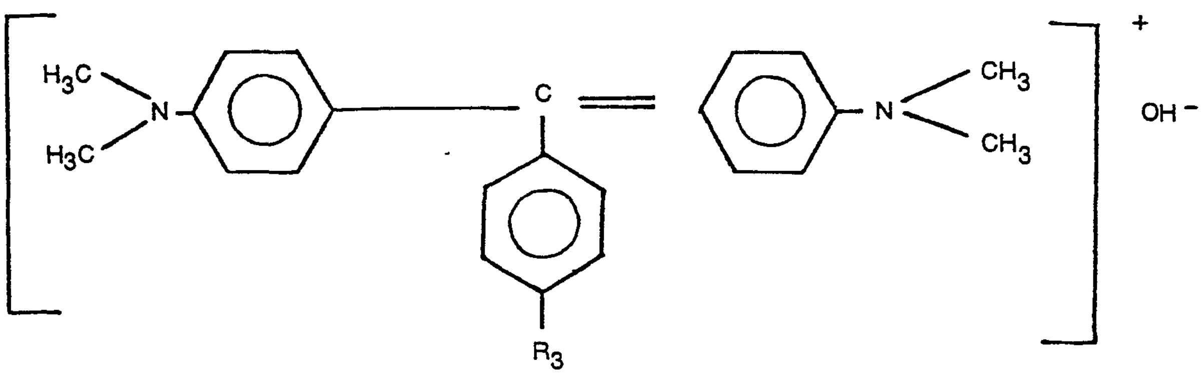

where $R_3$ is hydrogen or dimethyl amino.

The xanthene dyestuffs, whose free bases are useful herein, can be represented by the general formula:

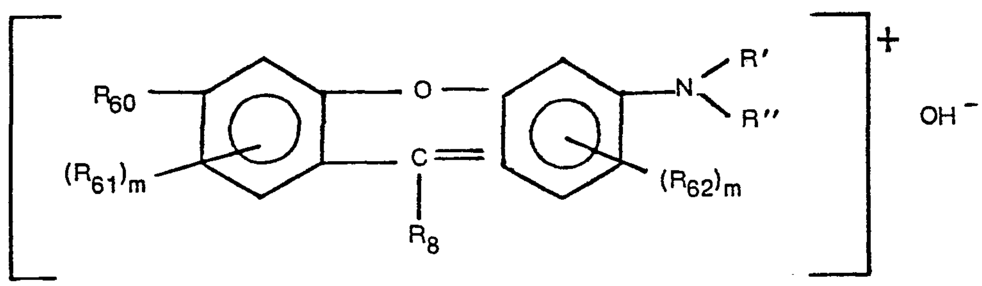

where $R_8$ is hydrogen or optionally substituted carbocyclic aryl $R_{60}$ is oxo, lower alkoxy, hydroxyl or

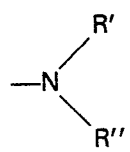

where R' and R'' are as previously defined;
*m* is an integer from one to three and
$R_{61}$ and $R_{62}$ are selected from the same group as $R_{10}$ and when m is two or three, the substituents can be the same or different.

A preferred group of xanthene dyestuffs are represented by the following structural formula:

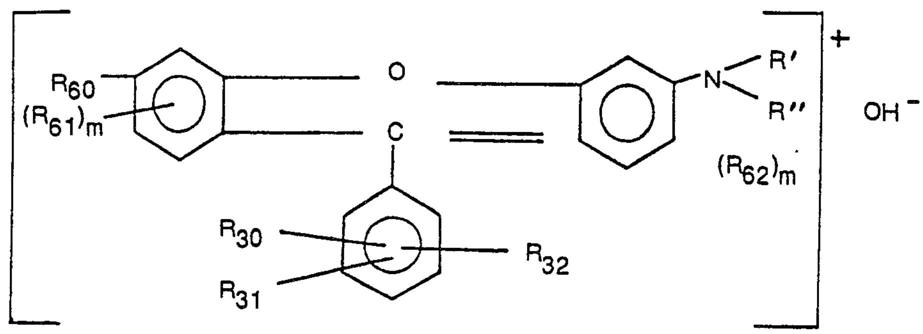

where $R_{60}$ is

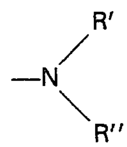

*m* is one or two and

$R_{30}$, $R_{31}$ and $R_{32}$ each independently is hydrogen, sulfamyl, sodium sulfo, halo, carboxyl, carboloweralkoxy, or hydroxyl.

A particularly preferred subgroup of compounds have the formula

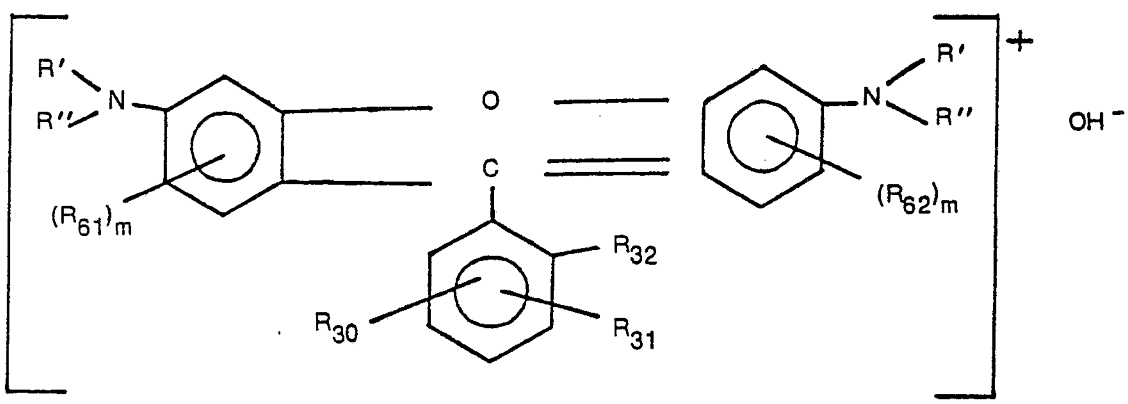

where R′ and R″ are hydrogen, lower alkyl, phenyl that is unsubstituted or substituted by lower alkyl or lower alkoxy
$R_{61}$ is lower alkyl
*m* is one
$R_{32}$ is carboxyl or carboloweralkoxy
$R_{30}$ and $R_{31}$ each independently is hydrogen, chloro, carboxyl or hydroxyl.

Amino derivatives of acridine dyestuffs whose free bases can successfully be employed herein have the general formula:

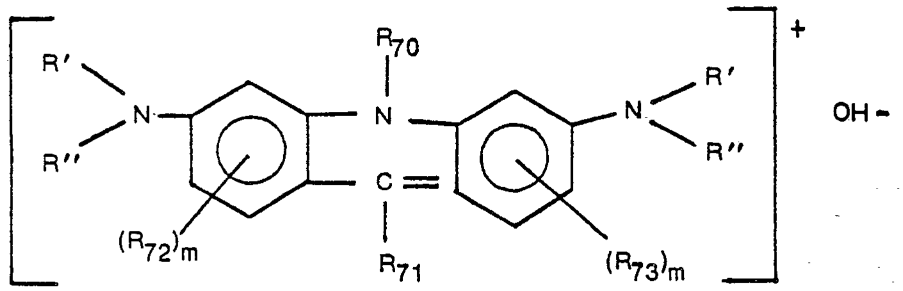

where $R_{70}$ is hydrogen or lower alkyl
$R_{71}$ is hydrogen, lower alkyl or phenyl that is unsubstituted or substituted by amino, carboxyl or di(loweralkyl)amino,
*m* is one, two or three
$R_{72}$ and $R_{73}$ each independently is hydrogen, lower alkyl or halogen
R' and R'' are hydrogen or lower alkyl.

The methine and polymethine dyestuffs whose free bases can be used are those having Colour Index numbers C.I. 48010 to 48080.

It should be noted that the dyestuffs described hereinabove are independently known to the art, for example, the amino derivatives of triarylmethane dyestuffs that are useful are those having the indicated formula and having a Colour Index number between C.I. 42,000 and C.I. 4,520; useful amino derivatives of xanthene dyestuffs are those having the indicated formula and having a Colour Index number between C.I. 45,000 and C.I. 45,505; the acridine dyestuffs are those having a Colour Index number between C.I. 46,000 and C.I. 46,080.

In the second aspect, the colorformer can be a fluoran compound.

Fluoran colorformer contemplated herein are those having the following formula:

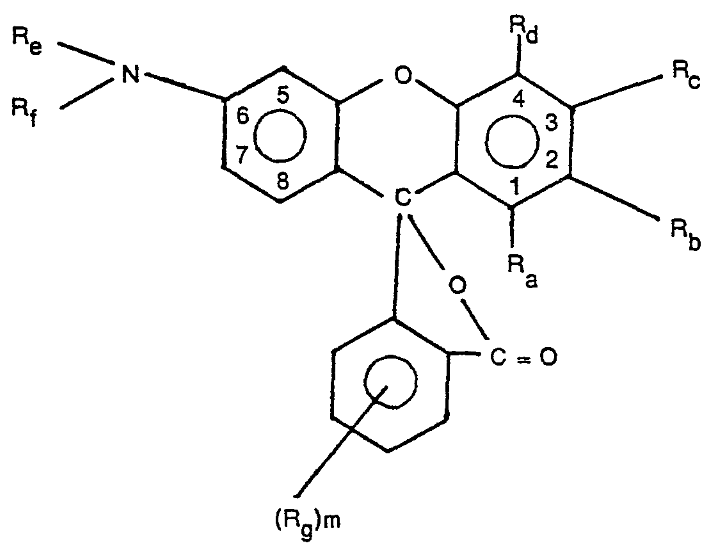

where
$R_a$ is hydrogen or an aliphatic group of one to 12 carbon atoms that is unsubstituted or optionally substituted and that may be interrupted by

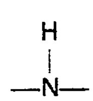 or —O—

and that is bound directly via carbon or oxygen;
$R_b$ is an amino group where one or both hydrogen atoms are optionally replaced by unsubstituted or substituted aliphatic groups, cycloaliphatic groups, aromatic groups or mixed aliphatic-aromatic groups or $R_b$ is a heterocyclic group of 3 to 12 ring members bound via a ring nitrogen and containing in addition to nitrogen, one or more of oxygen and sulfur as hetero ring members
or $R_a$ and $R_b$ together form a condensed aromatic nucleus;
$R_c$ is hydrogen, halogen, an aliphatic group of one to 12 carbon atoms that is unsubstituted or substituted and that may be interrupted by nitrogen or oxygen and that is bound directly via carbon or oxygen, or $R_c$ is an amino group where one or both hydrogen atoms are optionally replaced by unsubstituted or substituted aliphatic groups, cycloaliphatic groups, aromatic groups, mixed aliphatic-aromatic groups or where $R_c$ is a heterocyclic group with three to twelve ring members containing one or more of nitrogen, oxygen and sulfur as hetero ring members or $R_c$ is an aromatic group that is unsubstituted or optionally substituted or a mixed aliphatic-aromatic group or an aromatic ether or aliphatic-aromatic ether group;
$R_d$ is hydrogen, lower aliphatic or an amino group where one or both hydrogen atoms are optionally replaced by unsubstituted or substituted aliphatic groups, cycloaliphatic groups, aromatic groups, mixed aliphatic-aromatic groups or $R_d$ is a heterocyclic group of 3 to 12 ring members containing one or more of nitrogen, oxygen and sulfur as hetero ring members;

$R_e$ and $R_f$ each independently is hydrogen, unsubstituted or substituted aliphatic of one to 12 carbon atoms which may be interrupted by oxygen or nitrogen, and which is bound directly via carbon, cycloaliphatic groups, aromatic groups, mixed aliphatic-aromatic groups, or $R_e$ and $R_f$, together with the nitrogen atom form a heterocyclic group of 3 to 12 ring members, optionally containing, in addition to nitrogen, one or more of sulfur and oxygen as hetero ring members;

$(R_g)_m$ represents one to 3, independently, of hydrogen, lower aliphatic bound directly via carbon or oxygen, or is halogen, acetamido or optionally substituted amino.

Preferably, at least one of $R_b$, $R_c$ and $R_d$ is an amino group, as defined.

Particularly useful are the 2-amino fluoran compounds of formula

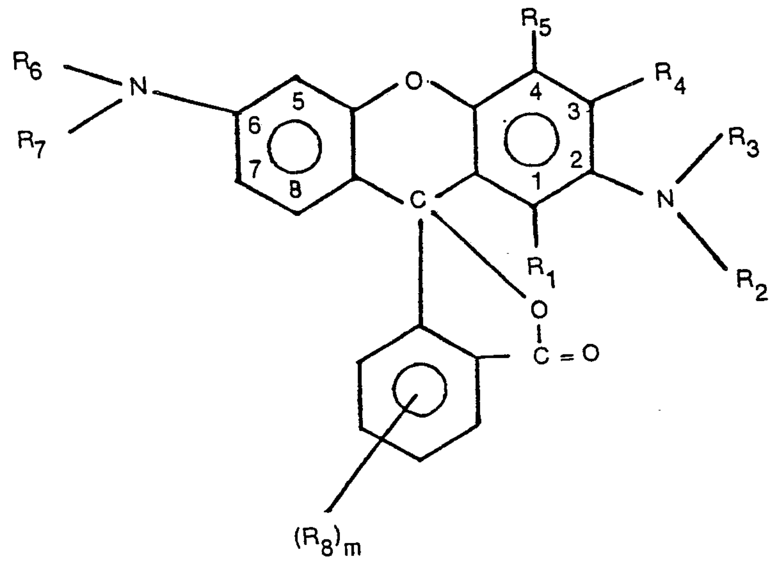

where

$R_1$ is hydrogen, halogen, alkyl of one to 12 carbon atoms, alkoxy of one to 12 carbon atoms

$R_2$ and $R_3$ each independently is hydrogen, alkyl of one to 12 carbon atoms, alkenyl of 2 to 12 carbon atoms, alkoxyalkyl of 2 to 8 carbon atoms, alkoxycarbonyalkyl of 3 to 9 carbon atoms; cycloalkyl of 5 or 6 carbon atoms, acyl of one to 12 carbon atoms, phenyl, naphthyl or benzyl that are unsubstituted or substituted in the aromatic nucleus by one of 3 of amino mono- or di-alkyl amino of one to 5 carbon atoms, alkyl of one to 7 carbon atoms, alkoxy of one to 7 carbon atoms, carboxyl, alkoxycarbonyl of 2 to 7 carbon atoms, acyl or acylamino of one to 5 carbon atoms, or $MeSO_3$— where Me is alkali metal or $R_2$ and $R_3$ together with the associated nitrogen atom form a heterocyclic radical of 3 to 12 ring members selected from pyrrolidinyl, piperidyl, pipecolinyl, perhydroazepinyl, heptamethyleneimino, octamethyleneimino, indolinyl, 1,2,3,4-tetrahydroquinolinyl, hexahydrocarbazolyl, morpholinyl, thiomorpholinyl, piperazinyl, N-alkyl piperazinyl where the alkyl group contains one to 4 carbon atoms, pyrazolinyl, or 3-methyl pyrazolinyl

$R_4$ is hydrogen, alkyl of one to 12 carbon atoms, alkoxy of one to 12 carbon atoms, halogen, amino that is unsubstituted or substituted by one or two of the substituents as defined for $R_2$ and $R_3$, or $R_4$ is phenyl, phenoxy, benzyl or benzyloxy that is unsubstituted or substituted in the aromatic nucleus by one to 3 of amino, mono- or di-alkyl amino of one to 5 carbon atoms, lower alkyl, lower alkoxy carboxyl, alkoxy carbonyl of 2 to 7 carbon atoms, acyl or one to 5 carbon atoms or $MeSO_3$— where Me is alkali metal

$R_5$ is hydrogen, lower alkyl, lower alkoxy or amino that is unsubstituted or substituted by one or two of the substituents as defined for $R_2$ and $R_3$, including the heterocyclic members,

$R_6$ and $R_7$, each independently is selected from the same group as defined for $R_2$ and $R_3$, including the heterocyclic members thereof;

$(R_8)_m$ represents one to 3 members independently selected from hydrogen, alkyl of one to 7 carbon atoms, alkoxy of one to 7 carbon atoms, halogen, acetamido, amino or mono- or di-alkyl amino of one to 7 carbon atoms.

Of the compounds described above, those wherein $R_1$, $R_5$ and $R_8$ are hydrogen are of particular interest. These compounds have the general formula

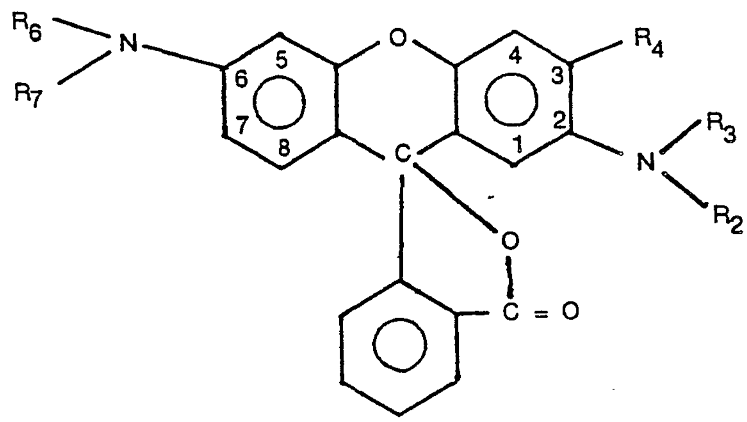

where
$R_2$, $R_3$, $R_4$, $R_6$ and $R_7$ are all as previously defined.

Of special interest are the compounds having the preceding formula wherein
$R_2$ is hydrogen, alkyl of one to 7 carbon atoms or acyl of one to 7 carbon atoms
$R_3$ is hydrogen, alkyl of one to 7 carbon atoms, acyl of one to 7 carbon atoms, phenyl, benzyl or naphthyl or where $R_2$ and $R_3$ together with the associated nitrogen atom form morpholinyl, piperazinyl, pyrrolidinyl or piperidinyl
$R_4$ is hydrogen, alkyl of one to 7 carbon atoms or alkoxy of one to 7 carbon atoms
$R_6$ and $R_7$ is each alkyl of one to 5 carbon atoms or together with the associated nitrogen form morpholinyl, piperazinyl, pyrrolidinyl or piperidinyl.

Especially preferred are the compounds of formula

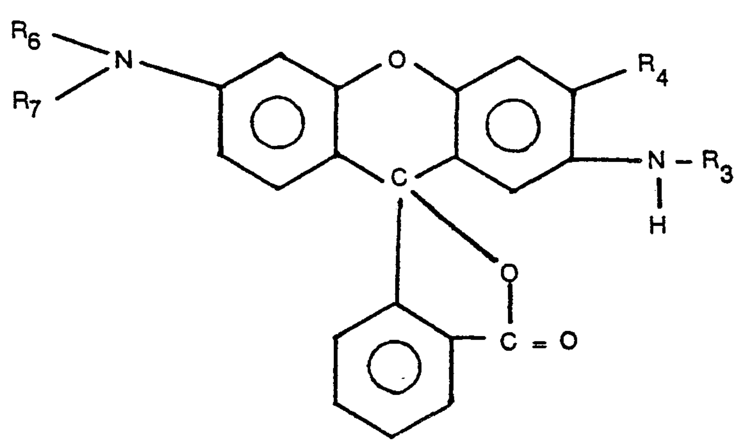

where
$R_3$ is hydrogen or phenyl
$R_4$ is hydrogen, $(C_1—C_3)$ alkyl or $(C_1—C_3)$ alkoxy
$R_6$ and $R_7$ is each $(C_1—C_3)$ alkyl; the compounds found to be notably useful are these where $R_6$ and $R_7$ are both ethyl and where $R_4$ is hydrogen, methyl or methoxy.

Fluoran compounds as described herein are known in the art; they are prepared by reacting a suitable benzophenone with an appropriate phenol derivative in the presence of an acidic condensing agent according to the following general formula

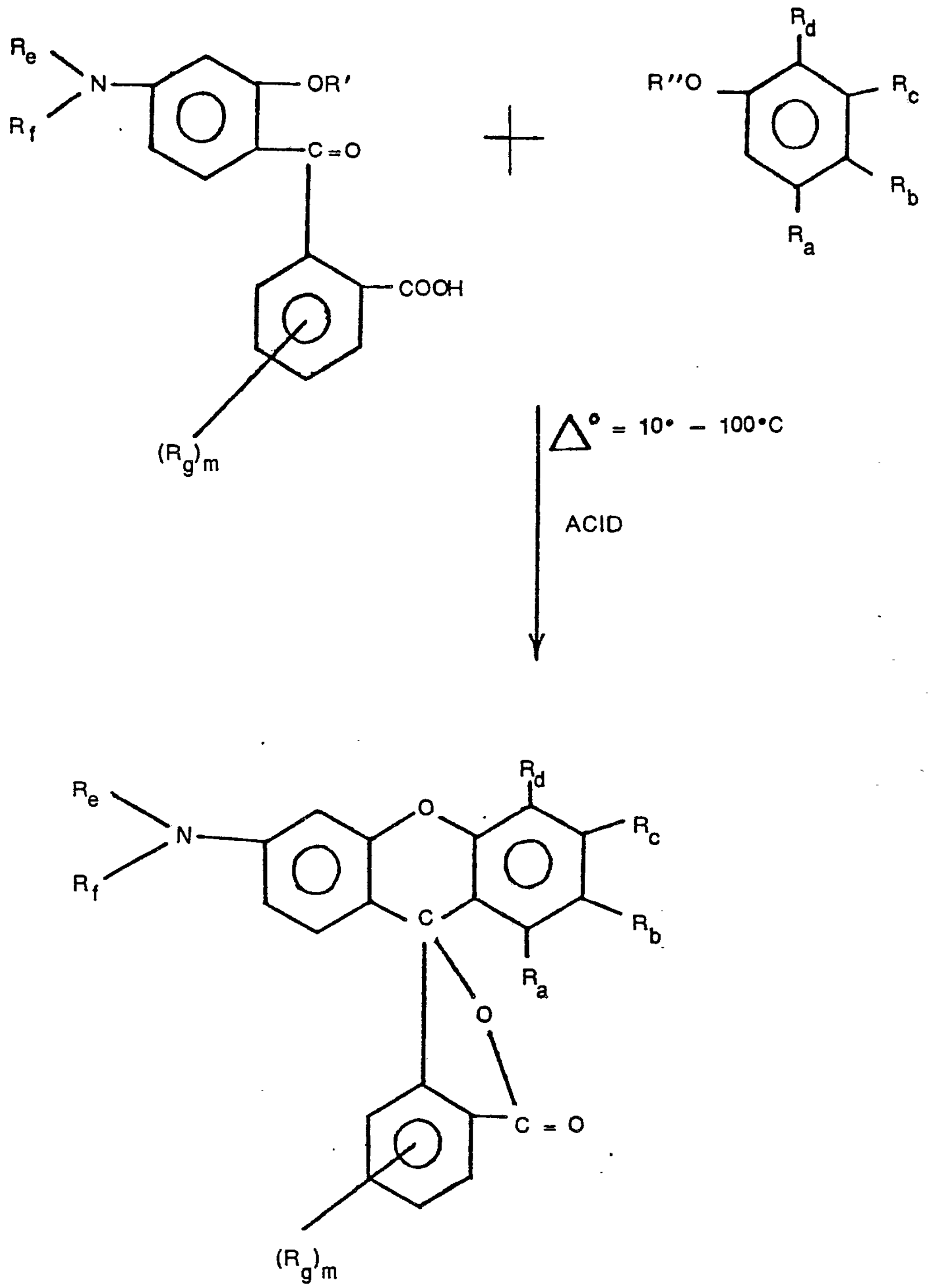


where $R_a$, $R_b$, $R_d$, $R_e$, $R_f$, and $R_g$ are as previously defined and R′ and R″ are hydrogen or lower alkyl, preferably hydrogen.

The reaction is typically carried out at 10° to 100°C in the presence of a condensing agent such as acetic anhydride, sulfuric acid, zinc chloride, phosphorous oxychloride and polyphosphoric acid for from 3 to 6 hours; after cooling, the solution is poured into ice water and the product is neutralized with suitable alkali such as an alkali metal hydroxide solution. The crystals are then recovered and purified in known manner, as by recrystallization.

The benzophenone compound can be prepared by reacting a phenol derivative with a phthalic anhydride in an organic solvent such as benzene, toluene, xylene and chlorobenzene, at reflux:

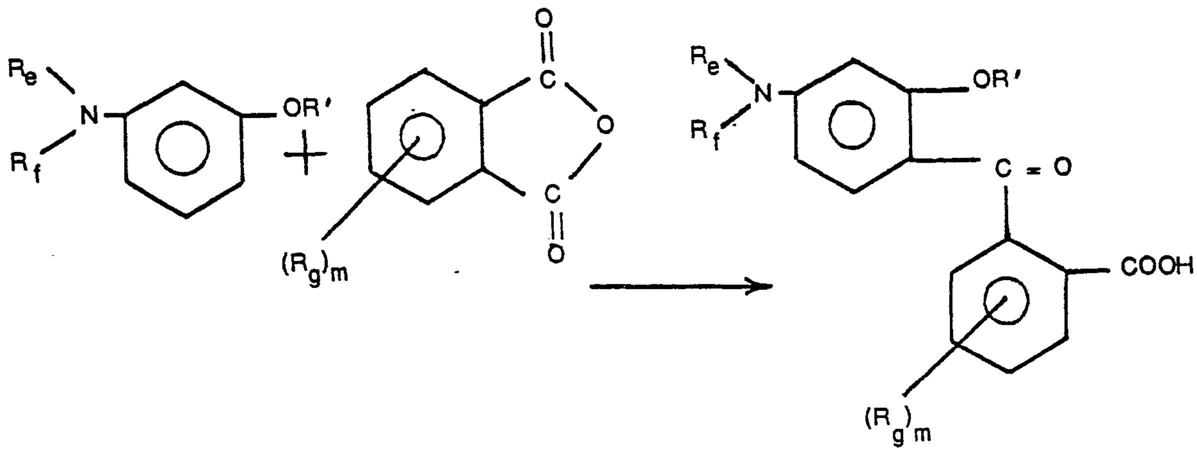

The general art of making fluoran compounds useful herein is described in U.S. Patents No. 4,007,195, 3,997,561, 3,929,831, 3,681,392, 3,514,310, 3,501,331 and in British Patents No. 1,339,316, 1,269,601, 1,211,393, the compounds described in these patents are also useful herein.

In describing the activators within the scope of this invention, it will be understood that the colorformers described herein are converted to dark-colored products by contact with an acidic substance. The acidic materials are those falling within the definition of a Lewis acid, that is, an electron acceptor. Thus the activators useful herein will either generate a Lewis acid or will facilitate the production of a Lewis acid from some other source.

The activators used in this invention requires the simultaneous presence of a proton donor and one of the specified carbonylic halides in the presence of a free radical type photoinitiator. Without wishing to be bound to any theoretical explanation for the chemistry of this activator system, the perceived results may be explained as follows. The proton donor (PD), whether by the effect of the free radical initiator (In) or otherwise, provides protons that are effective to convert the colorformer to the dark colored reaction product. The carbonylic halide compound, functioning as an electron sink, pushes the reaction to the right, encouraging proton formation:

$$In \xrightarrow{h\nu} In^{*} \xrightarrow{PD} \overset{\bullet -}{In} + \overset{\bullet +}{PD}$$

$$\overset{\bullet}{PD}{}^{+} \longrightarrow PD\cdot + H^{\oplus}$$

$$\overset{\bullet}{In}{}^{-} + RX \longrightarrow In + R\cdot + X^{-}$$

The proton donor may be an amine, an arsine or a phosphine and may be represented by the formula

$$\begin{array}{c} R'' \\ | \\ R'\text{—}D\text{—}R''' \end{array}$$

where

D is N, As or P,

R′ and R″, each independently is hydrogen, linear or branched chain alkyl having 1 to 12 carbon atoms, linear or branched alkenyl having from 2 to 12 carbon atoms, cycloalkyl having from 3 to 10 ring carbon atoms, cycloalkenyl of from 3 to 10 ring carbon atoms, aryl of from 6 to 12 ring carbon atoms, alkaryl of from 6 to 12 ring carbon atoms, aralkyl of from 6 to 12 ring carbon atoms,

R‴ has the same meaning as R′ and R″ except that it cannot be hydrogen and cannot be aryl when both R′ and R″ are aryl; the aryl groups can be unsubstituted or substituted by one or more of amino, mono- or di-(lower alkyl) amino, loweralkylcarbonyl, loweralkoxycarbonyl, loweralkylcarbonyloxy, phenylcarbonyl or aminophenylenecarbonyl where the amino group is unsubstituted or substituted by lower alkyl.

Additionally, R'' and R''' together with D can form a heterocyclic group. Thus R'' and R''' together can be divalent alkylene of 2 to 12 carbon atoms, divalent alkylene of 3 to 12 carbon atoms, divalent alkadienylene of 5 to 10 carbon atoms, divalent alkatrienylene of from 5 to 10 carbon atoms, divalent alkyleneoxyalkylene having a total of from 4 to 12 carbon atoms or divalent alkyleneaminoalkylene having a total of from 4 to 12 carbon atoms.

Because of ready availability, lower toxicity and stability, the amines are preferred; representative specific organic amines include methylamine, dimethylamine, trimethylamine, diethylamine, triethylamine, propylamine, isopropylamine, diisopropylamine, triisopropylamine, butylamine, tributylamine, t-butylamine, 2-methylbutylamine, N-methyl-N-butylamine, di-2-methylbutylamine, trihexylamine, tri-2-ethylhexylamine, dodecylamine, tridodecylamine, tri-2-chloroethylamine, di-2-bromoethylamine, methanolamine, ethanolamine, diethanolamine, triethanolamine, N-methyldiethanolamine, N,N-dimethylethanolamine, N-methyldiethanolamine, isopropanolamine, propanolamine, diisopropanolamine, triisopropanolamine, N-butylethanolamine, dihexanolamine, 2-methoxyethylamine, di-2-ethoxyethylamine, tri-2-ethoxyethylamine, 2-hydroxyethyldiisopropylamine, 2-aminoethylethanolamine, allylamine, butenylamine, dihexadienylamine, cyclohexylamine, tricyclohexylamine, trimethylcyclohexylamine, bis-methylcyclopentylamine, tricyclohexenylamine, tricyclohexadienylamine, tricyclopentadienylamine, N-methyl-N-cyclohexylamine, N-2-ethylhexyl-N-cyclohexylamine, phenyldimethylamine, p-acetylphenyldimethylamine, p-caprylyphenyl dimethylamine, methylphenylamine, ditolylamine, p-dimethylaminophenyl acetate, p-dimethylaminophenyl valerate, triphenethylamine, benzyldimethylamine, benzyldihexylamine, ethyl dimethylaminobenzoate, heptyl dimethylaminobenzoate, trischlorophenethylenimine, N-methylethylenimine, N-cyclohexylethylenimine, piperidine, N-ethylpiperidine, 2-methylpiperidine, 1,2,3,4-tetrahydropyridine, 1,2-dihydropyridine, 2-, 3- and 4-picoline, morpholine, N-methylmorpholine, N-2-hydroxy ethylmorpholine, N-2-ethoxyethylmorpholine, piperazine, N-methylpiperazine, N,N'-dimethylpiperazine, 2,2-dimethyl-1,3- bis [3-(N-morpholinyl)propionyloxyl] propane, 1,5-bis [3-(N-morpholinyl)propionyloxy diethyl] ether, N,N-dimethylbenzylamine, ethyldiethanolamine; triethanolamine; p-nitroaniline; n-acetyl-4-nitro-1-naphthylamine; aminoanthraquinone.

A preferred group of amines are the p-aminophenyl ketones of general formula

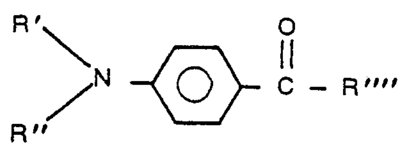

Where R' and R'' are alkyl of one to 4 carbon atoms and R'''' is alkyl of one to 12 carbon atoms, alkoxy of one to 12 carbon atoms, phenyl, loweralkyliminophenylene or di(loweralkyl) aminophenylene.

Representative compounds include p-(dimethylamino) acetophenone; p-(dimethylamino) propiophenone; p-(dimethylamino) butyrophenone; p-(dimethylamino) valerophenone; p-(dimethylamino) myristylphenone; the p-(diloweralkylamino) benzoic acid esters such as p-(dimethylamino) benzoic acid ethyl ester; p-(dimethylamino) benzoic acid butyl ester; p-(dimethylamino) benzoic acid lauryl ester; p-(dimethylamino) benzoic acid myristyl ester; 4-dimethylaminobenzophenone; 4-dimethylamino-4'-propylaminobenzophenone; and 4,4'-bis(dimethylamino)benzophenone.

As indicated, the compositions of this invention are formulated with the specified carbonylic halides. These are the halogenated aliphatic ketones, the halogenated cycloaliphatic ketones and the esters and amides of halogenated aliphatic dicarboxylic acids. While all these compounds are operative, particularly preferred results are obtained when the halogen atom is located adjacent to the carbonyl group. It may be hypothesized that the carbonyl group affects the alpha-halogen atoms in a manner analogous to the effect of the carbonyl group on the alpha-hydrogens; in any event the preferred carbonylic halides are those having at least one halogen atom on carbon atom alpha- to a carbonyl group. Especially preferred are the carbonylic halides having two halogen atoms on an alpha-carbon atom.

One group of halogenated aliphatic ketones has from 3 to 13 carbon atoms and from one to 4 carbonyl groups; these compounds are represented by the general formula

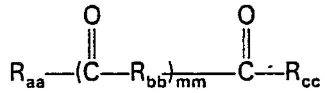

where

$R_{aa}$ is alkyl or haloalkyl containing one to eleven carbon atoms; $R_{bb}$ is alkylene or haloalkylene containing one to ten carbon atoms, or $R_{bb}$ represents a covalent bond; $R_{cc}$ is alkyl, haloalkyl, alkoxy, or haloalkoxy containing one to eleven carbon atoms; mm is 0, 1, 2 or 3 and at least one of $R_{aa}$, $R_{bb}$ and $R_{cc}$ contains at least one halogen atom.

These compounds are exemplified by:
1,1-dichloroacetone
1,1-dibromoacetone
1,3-dichloroacetone
Hexabromoacetone
hexachloroacetone
phentachloroacetone
1,1,1-trichloroacetone
1,1,3,3-tetrachloroacetone
iodoacetone
1,4-dichloro-2-butanone
3,4-dibromo-2-butanone
3,3-dibromo-2-butanone
2-iodo-3-pentanone
1,3,5-trichloro-2-pentanone
4,4-dimethyl-3,3-dibromo-2-pentanone
3-iodo-2-hexanone
2,6-dimethyl-4,4-dibromo-3-heptanone
3,3-dibromo-2-heptanone
3,3-dichloro-4-heptanone
4-iodo-3-octanone
4,4-dibromo-5-nonanone
3-bromo-4-ethoxy-2,4-butanedione
1,1-dibromo-4-ethoxy-2,4-butanedione
1,4-dibromo-2,3-butanedione
1-methoxy-2-chloro-1,3-butanedione
1-methoxy-3-bromo-1,2-butanedione
3-bromo-2,4-pentanedione
1,4-dibromo-2,3-hexanedione
4,4-dibromo-2,3-hexanedione

Another group of carbonylic halides is formed by the cyclic ketones containing one or two ring carbonyl groups; preferred are the carbocyclic ketones of formula

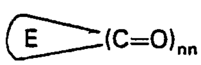

where E is the halogenated residue of a carbocyclic ketone which, including the bound carbonyl group or groups contains from 4 to about 8 carbon atoms in the ring; and may be substituted, in adddition to halogen, by lower alkyl, lower alkoxy or acyl having two to 6 carbon atoms; and nn is 1 or 2.

These compounds are illustrated by:
perchloro-2-cyclobuten-1-one
2,2,4,4-tetrabromocyclobutanone
2-chlorocyclopentanone
2,2,5,5-tetrabromocyclopentanone
2-bromo-3-acetylcyclopentanone
2-chlorocyclohexanone
2,2,6,6-tetrabromocyclohexanone
3-ethoxy-2,3-dibromocyclohexanone
3,5-dimethyl-2,3-dibromocyclohexanone
2,2-dibromo-3-acetylcyclohexanone
3,3-dichloro-2,2-dihydroxycyclohexanone
3,6-dichloro-1,2-cyclohexanedione
hexachloro-2,4-cyclohexanedione
3,6-dibromo-1,2-cyclohexanedione
3,3-dibromo-1,4-cyclohexanedione
2,3-dibromo-1,4-cyclohexanedione
2-iodo-1,3-cyclohexanedione
2-iodo-1,3-cyclopentanedione
2,2-dibromo-5,5-dimethyl-1,3-cyclohexanedione
2,2-dibromo-4,4-dimethyl-1,3-cyclohexanedione

Another grup of compounds useful herein are the esters and amides of formula:

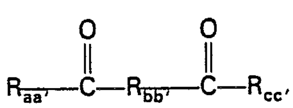

where

$R_{aa'}$ is an amino group which may be substituted by one or two lower alkyl or lower haloalkyl groups, or $R_{aa'}$ is alkoxy or haloalkoxy group having one to 4 carbon atoms, or $R_{aa}$ is

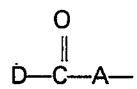

where D is alkoxy or haloalkoxy group having one to 4 carbon atoms and —A— is alkylene or haloalkylene group having one to 4 carbon atoms; $R_{bb'}$ is a covalent bond or an alkylene or haloalkylene group having one to 4 carbon atoms or is the group:

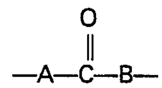

in which each of A and B is an alkylene or haloalkylene group having one to 4 carbon atoms; or $R_{cc'}$ is an amino group which may be substituted by one or two lower alkyl or lower haloalkyl groups, or is an alkoxy or haloalkoxy group having one to 4 carbon atoms, at least one of $R_{aa'}$, $R_{bb'}$, and $R_{cc'}$ containing at least one halogen atom.

These compounds will contain up to 12 carbon atoms and are illustrated by:

dimethyl dibromomalonate
diethyl dibromomalonate
diethyl iodomalonate
dibromomalonamide
iodomalonamide
α,α'-dibromosuccinate
diethyl α,α'-dibromosuccinate
methyl α-bromoglutarate
α-iodoglutaramide
dimethyl α,α'-dichloroglutarate
3-bromo-2-ketoglutaramide
dimethyl-3-iodo-4-ketopimaleate
diethyl-1,3-dibromo-1,3-acetonedicarboxylate
diethyl-3,6-dibromo-1,4-cyclohexanedione-2,5-dicarboxylate

From the foregoing, it is apparent that in one aspect the invention relates to a phototropic photosensitive composition comprising:

a. an ethylenically unsaturated component capable of free radical initiated curing, crosslinking or polymerization;
b. a free radical generator;
c. a colorformer selected from
   (i) free bases of amino dyestuffs
   (ii) fluoran compounds;
d. an activator for the colorformer
   (i) a hydrogen donor
   (ii) a halogenated carbonylic compound from the specified kinds.

Where the free radical generator is a combination that includes a hydrogen·donor, such as benzophenone, and an amine, such as an alkylamino benzophenone, another hydrogen donor need not be added. Thus an amine, if present, can perform two functions: as a chain transfer agent and as a proton donor in connection with activation of the fluoran colorformer.

In the preferred embodiments the photosensitive phototropic composition comprises:

a. an acrylyl or methacrylyl compound
b. a photoinitiator
c. a fluoran colorformer
d.1. an amine
   2. a carbonylic halide selected from halogenated aliphatic ketones of 3 to 13 carbon atoms, halogenated carbocyclic ketones of 4 to 8 ring carbon atoms, esters and amides of halogenated dicarboxylic acids and esters and amides of halogenated keto acids.

The particularly preferred embodiments are those where the photoinitiator is one or more of a benzoin ether, benzophenone, a derivative of benzophenone, a monoaryl ketone, a xanthone, a thioxanthone, or a quinone, the fluoran colorformer is a 2-amino fluoran and the amine is a tertiary amine and the carbonylic halide contains at least one alpha halogen.

Thus, in the particularly preferred embodiments, the compositions comprise

a. an acrylyl or methacrylyl compound

b. a benzoin ether, benzophenone, a lower alkylamino benzophenone, a monoaryl ketone, a xanthone, a thioxanthone, a quinone or mixture thereof

c. a 2-amino fluoran colorformer

d.1. a tertiary amine

2. a carbonylic halide containing at least one alpha halogen, selected from halogenated aliphatic ketones of 3 to 13 carbon atoms, halogenated carbocyclic ketones of 4 to 8 ring carbon atoms, esters and amides of halogenated dicarboxylic acids containing up to 12 carbon atoms and esters and amides of halogenated keto acids containing up to 12 carbon atoms.

The compositions of the present invention may be used in relatively thick layers or may be cast as thin films having thicknesses of from 0.25 to 5 mils or even more. When prepared in the form of an assembly comprising a support, composition and transparent sheet, i.e., dry film photoresist, the composition will generally be from 0.5 to 5 mils thick. Suitable base or support materials include metals such as steel, aluminum, and copper in the form of plates, sheets and foils; film-forming synthetic resins or high polymers such as addition polymers and copolymers of vinyl chloride, vinylidenechloride, vinyl acetate, acrylonitrile, ethylene, propylene, etc.; and condensation polymers such as polyethylene terephthalate and polyamides and thermoset composites such as fibreglass-epoxy and paper-phenolic laminates.

A typical useful dry film resist will contain:

| Component | Broad Range (weight %) | Preferred Range (weight %) |
|---|---|---|
| Preformed polymer binder | 40—68.79% | 50—67.8% |
| Polymerizable, curable or crosslinkable component | 30—50% | 30—40% |
| Photoinitiator(s) | 1—10 | 1—5% |
| Fluoran Colorformer | 0.01—2% | 0.5—1.5% |
| Carbonylic halide | 0.1—5% | 0.5—2% |
| Amine | 0.1—10% | 0.2—5% |

The dry film phototropic photosensitive composition can additionally contain other conventional components such as thermal polymerization inhibitors, antioxidants, adhesion promoters and the like.

In use, the photopolymerizable dry film is exposed to a source of actinic radiation which may be through a half tone image or a process transparency; e.g., a process negative of positive; stencil or a mask. Exposure may also be through a continuous tone, negative or positive image. The exposure can be by the contact or projection method, with or without a coversheet over the photopolymerizable layer or by projection using a cover sheet. These procedures are well known to those skilled in the art. The photoresist compositions are generally used in conjunction with ultraviolet light and the radiation source should furnish an effective amount of this radiation; point or broad radiation sources are effective. Such sources include carbon arcs, mercury-vapor arcs, fluorescent lamps with ultraviolet radiation emitting phosphors, argon glow lamps, electronic flash units and photographic flood lamps. Of these, the mercury vapor arcs, particularly the sun lamps, are most suitable.

The dry film photoresist compositions after exposure can be developed in known manner, for example by impingement of spray jets, with agitated immersion, brushing or scrubbing to desirable images with an organic solvent or mixture thereof capable of washing away the unexposed portions of the resist film. Useful solvents include cellosolve acetate, ethyl acetate, methyl ethyl ketone, acetone, trichloroethylene, carbon tetrachloride, tetrachloroethylene, the alkanols of one to four carbon atoms, butyl cellosolve, chlorobenzene and dimethylformamide. Where the resist has been formulated to be developed by aqueous alkali, solutions of sodium carbonate, sodium hydroxide, trisodium phosphate and the like can be used, either alone or in admixture with each other or with one or more solvents.

The phototropic compositions are also useful in ultraviolet-curable coating and printing compositions. One advantage that attends such compositions formulated with the phototropic dye systems is that thicker coatings can be employed than was previously the case since actinic light can penetrate through to the bottom of the coating before the color of the composition has intensified. Since color can now be obtained without pigments and the like which interfere with the penetration of actinic light, thicker, more resistant coatings are obtainable.

The coating and printing compositions will generally contain from about .1 to about 2% of fluoran compound, from about .1 to about 5% of carbonylic halide from 0.1 to 10% of amine; the compositions will

generally contain from about 1 to 10% by weight of photoinitiator. The balance of the compositions will be monomeric (including reactive oligomers) compounds, polymeric binders, plasticizers, adhesion promoters, antioxidants, fillers, thixotropic agents and levelling agents. Pigments can be added if desired.

These compositions can be applied by screen or other printing techniques or by brushing, roller coating, knife coating, curtain coating, etc.

The acrylyl and methacrylyl compounds, notably the acrylyl oligomers and esters, as described above, are particularly useful.

One useful class of oligomers is obtained by reacting an organic polyether or polyester polyol with a diisocyanate to provide an isocyanate-terminated prepolymer. This product can be reacted with an unsaturated alcohol, such as a hydroxy alkyl acrylate to provide, either alone or in combination with other unsaturated monomers, a material that will polymerize under the influence of free radicals to form a hard, tough, adherent film.

In a variation of the foregoing, a polymercaptoester such as trimethylolpropane-tris-(thioglycolate), trimethylolpropane tris-(mercaptopropionate); pentaerythritol tetrakis-(thioglycolate); pentaerythritol tetrakis-(mercaptopropionate); and the like are reacted with a diisocyanate to provide a polythiourethane intermediate which can be reacted with an unsaturated alcohol, such as a hydroxy acrylate to provide, either alone or in combination with other unsaturated monomers, free radical polymerizable material having excellent film properties after crosslinking.

Another illustration of a useful oligomer is an acrylate-capped polycaprolactone polyurethane, obtained by reacting a hydroxy-terminated polycaprolactone with a diisocyanate and thereafter reacting the isocyanate-terminated intermediate with an unsaturated alcohol such as a hydroxyalkyl acrylate.

Still another useful class of oligomers is obtained by reacting an epoxy resin with acrylic acid to obtain an epoxy diacrylate. For example, an epichlorohydrin/bisphenol A-type epoxy resin can be reacted with a stoichiometric amount of acrylic acid. Such products are available commercially as under the trademark "Epocryl" from Shell Chemical Company. Such materials can be combined with a variety of acrylic esters including neopentyl glycol diacrylate, hydroxyethyl acrylate and dicyclopentenyl acrylate and other unsaturated esters of polyols including such esters of methylene carboxylic acid such as, ethylene glycol diacrylate; diethylene glycol diacrylate; glycerol diacrylate; glycerol triacrylate; ethylene glycol dimethacrylate; 1,3-propylene glycol dimethacrylate; 1,2,4-butanetriol trimethacrylate; 1,4-benzenediol dimethacrylate; pentaerythritol tetramethacrylate; 1,3-propanediol diacrylate; 1,6-hexanediol diacrylate; the bisacrylates and methacrylates of polyethylene glycols of molecular weight 200—500; trimethylolpropane triacrylate; pentaerythritol triacrylate; and other ethylenically unsatruated compounds, to polymerize under the influence of free radicals to form films of excellent adhesion and toughness.

Another composition comprises a combination of a terminally unsaturated urethane composition (polyene) and a polythiol which are polymerizable under the influence of free radicals generated by the action of actinic light on a photoinitiator.

The coating and printing ink compositions will contain a predominant amount of film-forming materials and photosensitizer and a relatively minor amount of fluoran compound halogen compound and amine. For example, a typical composition will contain from 15 to 70% by weight of an ethylenically unsaturated compound as described above, 10—50% of one or more unsaturated monomers or of a preformed polymeric binder, 0.1 to 10% by weight of a photoinitiator; 0.01 to 2% by weight of fluoran compound as described above, 0.1 to about 5% of carbonylic halide and 0.1 to 10% of amine. A more narrow range is from about 40 to about 55% by weight of ethylenically unsaturated compound, from 30—45% of monomer or of polymeric binder from 1 to 5% of initiator, from 0.5 to 1.5% of fluoran compound, from 0.5 to 2% of halogen compound and from 0.2 to 5% of amine.

The invention is further illustrated by the following examples.

Examples A to H illustrate the preparation of a variety of useful fluoran colorformers.

Example A

2-anilino-6-dimethylaminofluoran

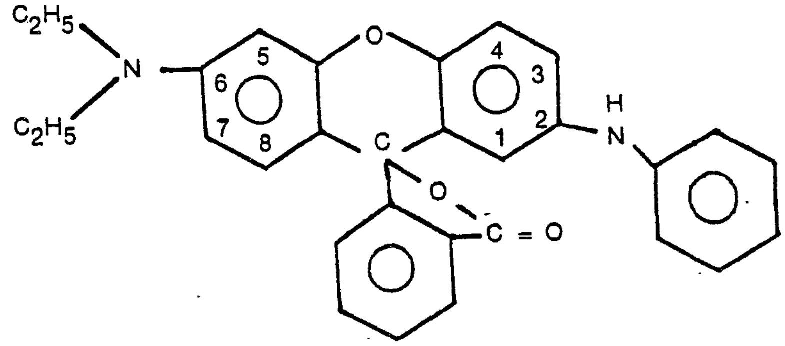

Heat together 2.2 parts by weight of 2-carboxy-4'-diethylamino-2'-hydroxybenzophenone, 1 part by weight of p-nitrophenol and 40 parts by weight of 90 weight percent $H_2SO_4$ for about 1 hour at 150°C. Thereafter pour the mixture into about 225 parts by weight of ice and raise the pH to about 8 by addition of dilute $NH_4OH$. Extract this solution with benzene and thereafter wash the benzene with 10 percent by weight of aqueous NaOH and then with water. Purify the washed benzene extracted by passage through an activated alumina chromatograph column. Concentrate the resulting solution by evaporation, add petroleum ether and recrystallize. Reduce the product with stannous chloride solution, extract with benzene and recrystallize to obtain 2-amino-6-diethylaminofluoran. Reflux 7.8 parts by weight of this product, 4 parts by weight of o-bromobenzoic acid, 2.8 parts by weight of potassium carbonate, 0.1 part by weight of copper powder and 40 parts by weight of amyl alcohol for about 3 hours. Cool and add petroleum ether to separate the crude reaction product. Heat the crude reaction product of 250—260°C to decarboxylate, then dissolve in benzene and wash twice with 1 weight percent aqueous sodium carbonate and once with water. Concentrate the benzene solution by evaporation and precipitate with petroleum ether. Dissolve the product in benzene, purify over activated alumina, recrystallize using petroleum ether and recover the product.

Example B

2-(2'-methoxycarbonyl anilino)-6-diethylamino fluoran

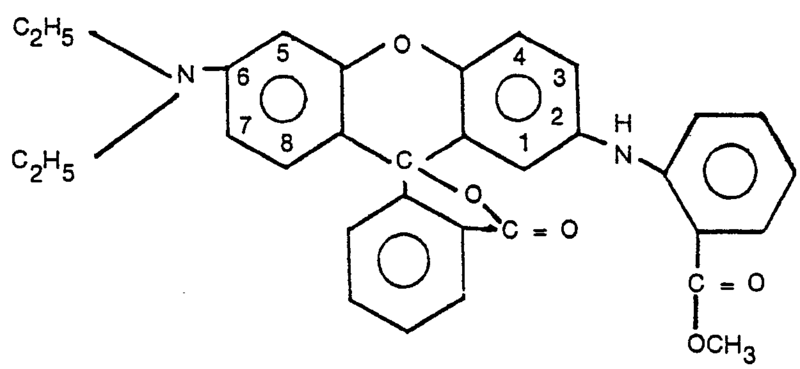

The crude reaction product of Example A is methylated by refluxing 1 part by weight of said reaction product with 0.3 parts by weight of dimethylsulfate, 0.5 parts by weight of dicyclohexylamine and 12 parts by weight of acetone for about 15 minutes. Evaporate the solvent and then heat over a steam bath for an additional 15 minutes. Extract with benzene and purify through activated alumina. Concentrate by evaporation and add petroleum ether to crystallize the reaction product.

Example C

2-(2'-methoxycarbonyl-anilino)-3-methyl-6-diethylaminofluoran

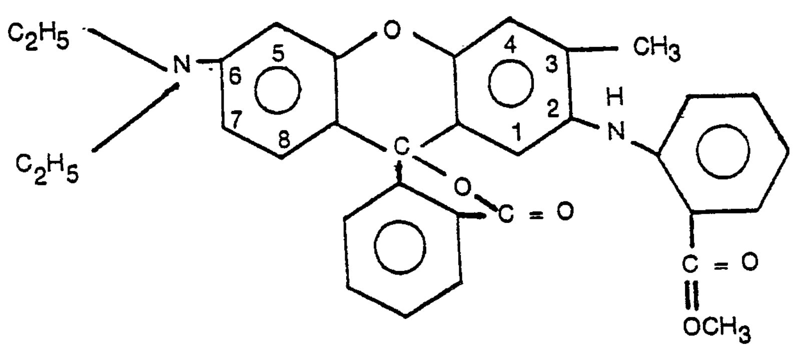

Following the procedure of Example A, but using 3-methyl-4-nitrophenol in place of p-nitrophenol, there is obtained 2-amino-3-methyl-6-diethylaminofluoran. Reacting this product with o-bromobenzoic acid in the manner described in Example A provides the carboxylic acid-containing crude reaction product. Methylating this crude product according to Example B provides the desired product.

Example D
2-anilino-3-methyl-6-diethylaminofluoran

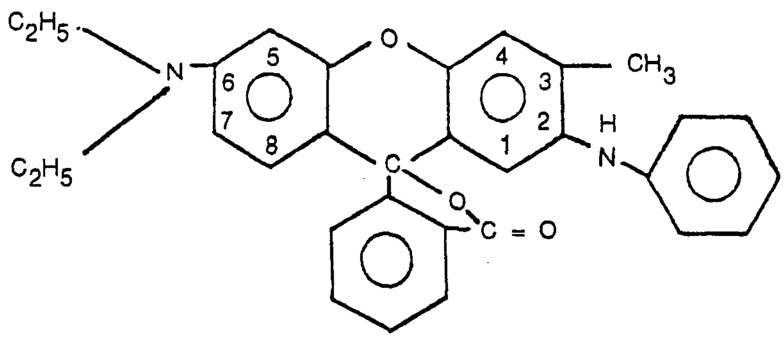

Decarboxylation of the carboxylic acid-containing crude reaction product of Example C as described in Example A provides the desired product.

By an alternate route, one gram of 2'-carboxy-4-diethylamino-2-hydroxybenzophenone can be dissolved in a mixture of 4 ml. of concentrated sulfuric acid and an equal volume of fuming sulfuric acid at an $SO_3$ content of 20% with mechanical stirring, and externally cooled to about 15°C. Add 1.9 grams of 4-amino-3-methylphenol gradually and continue stirring over 16 hours at about 20°C. Thereafter, pour the reaction mixture into about 200 grams of ice-water, raise the pH to about 8 with a 10 percent by weight aqueous solution of NaOH and extract with benzene. Wash the benzene successively with 10% NaOH, 2% NaCl and then water. Concentrate by evaporation, purify over activated alumina, elute with a 3:3:1 mixture of benzene:ethyl:ethyl acetate, evaporate and recover the product.

Example E
2-anilino-6-diethylamino-3-methoxyfluoran

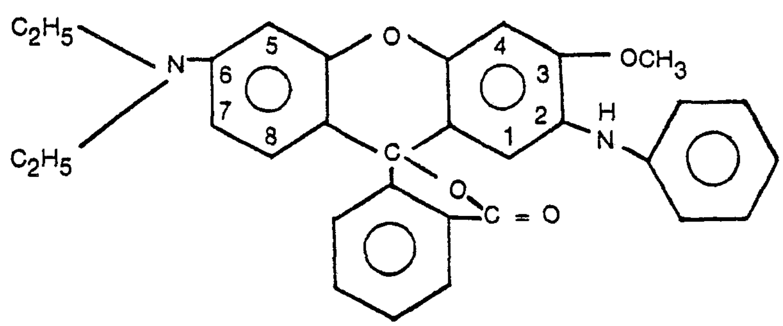

Following the alternate procedure described in Example D but using 4-amino-3-methoxyphenol instead of 4-amino-3-methylphenol, there is obtained the indicated product.

Example F
2-(N-benzylamino)-6-N-pyrrolidinylfluoran

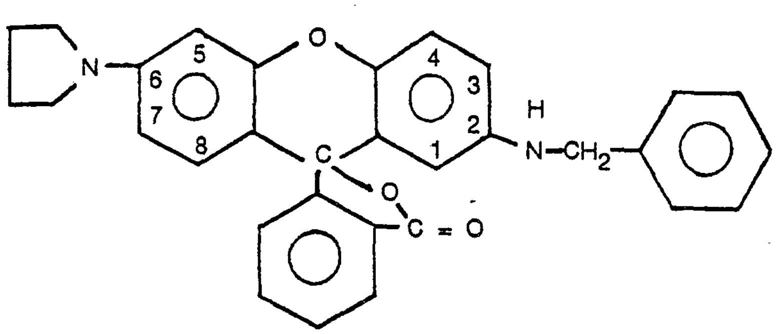

Stir a mixture of 77.75 grams of 2'-carboxy-2-hydroxy-4-N-pyrrolidinylbenzophenone, 75.6 grams N-benzyl-p-anisidine and 250 ml of 98% $H_2SO_4$ at 60°C for 5 hours and then quench into 2,750 ml. ice water. Filter the solid, wash with water and add the solid to a mixture of 500 ml. water, 250 ml. methanol and 26.8 grams NaOH at 70°C. Boil this mixture for 2 hours and cool to 85°C. Filter the solid product, wash with hot water, recrystallize from methanol/acetone and dry. The starting benzophenone compound can be prepared by heating a mixture of 74 grams phthalic anhydride 81.5 grams 1-(3'-hydroxyphenyl) pyrrolidine and 335 ml. xylene for 6 hours at 125°C. Cool to 25°C., filter the precipitate, wash with methanol and recrystallize from ethanol.

Example G
2,6-di-(N-pyrrolidinyl) fluoran

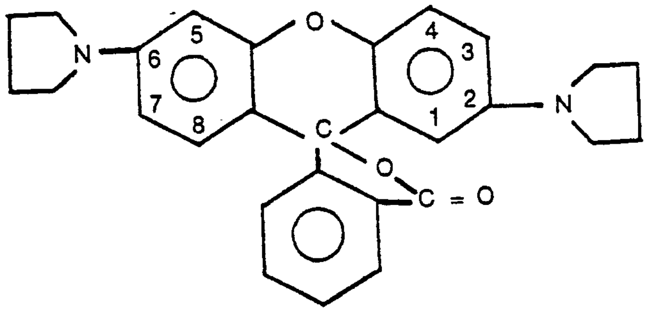

Following the procedure of Example F, but condensing the 2'-carboxy-2-hydroxy-4-N-pyrrolidinyl-benzophenone with 1-(4'-hydroxyphenyl) pyrrolidine, instead of N-benzyl-p-anisidine, there is obtained the indicated product.

Example H
2-methyl-4-amino-6-diethylaminofluoran

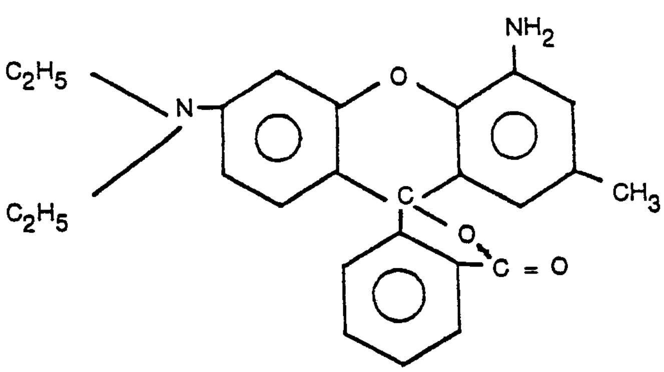

React 2'-carboxy-2-hydroxy-4-diethylamino benzophenone with 4-methyl-2-nitrophenol according to the procedure of Example A and then reduce the product by suspending one part by weight of product in a solution of 2.5 parts by weight of stannous chloride, 2 parts by weight of HCl having a specific gravity of 1.15 and about .6 parts by weight of water; warm and stir the suspension until a solution forms. Cool the solution to room temperature, dilute with about 2 parts by weight of water and raise the pH to about 12 with a 10 weight percent aqueous NaOH solution. Recover and purify the precipitate by washing, extraction and recrystallization, as indicated in the previous examples.

Example 1

Colorformers are evaluated with respect to phototropic capacity in the following composition:

| | Parts by wt. | |
|---|---|---|
| Acryloid A—101[a] | 60.3 | (solids basis) |
| Trimethylolpropane triacrylate | 19.6 | |
| Tetraethylene glycol diacrylate | 9.8 | |
| 2-Chlorothioxanthenone | 3.4 | |
| 2,2'-methylene bis (4-ethyl-6-t-butyl) phenol | .18 | |
| Modaflow[b] | .15 | |
| Tricresyl phosphate | 4.31 | |
| 4,4'-bis (dimethylamino)benzophenone | 0.45 | |
| Halide[c] | 1.51 | |
| Colorformer | 0.3 | |
| | | 100.0 |
| Methyl ethyl ketone | 195 | |

(a) an acrylic ester polymer in organic solvent from Rohm & Haas Company.
(b) a hydrocarbon flow control agent from Monsanto Chemical Co.
(c) TBCY = 2,2,6,6-tetrabromocyclohexanone
DDB = dimethyldibromomalonate

The composition is coated onto a 1-mil thick polyester film and dried in air. The dry thickness of the photosensitive composition is 1—2 mils. The dried layer is covered with a 1-mil thick polyethylene film.

The phototropic capacity is determined visually by removing the polyethylene film, laminating the photopolymerizable composition to a copper-clad panel, placing a light mask over the assembly and exposing this combination to a mercury vapor lamp for 30 seconds. The image is read immediately. Zero means no image, a negative rating indicates the dye system is photofugitive (i.e., fades) while a positive rating indicates the system has darkened in response to the light and is phototropic.

Fluoran compounds, color and phototropic capacity are indicated below:

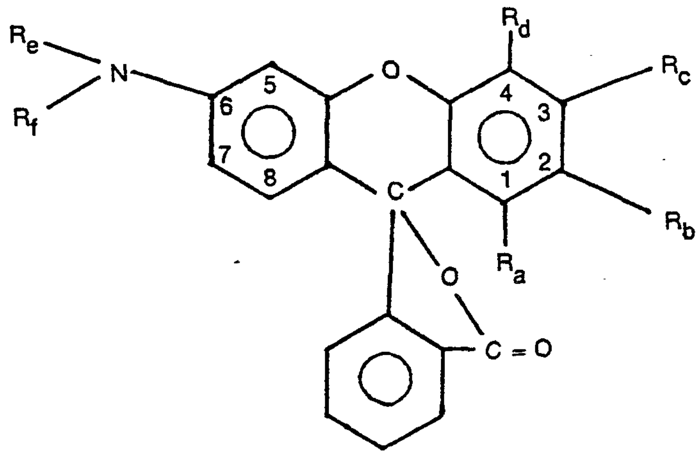

| $R_a$ | $R_b$ | $R_c$ | $R_d$ | $R_e$ | Rf | Developed Color | Phototropic Capacity |
|---|---|---|---|---|---|---|---|
| H | 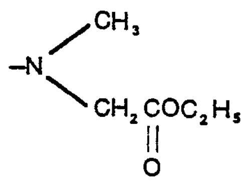 | H | H | $C_2H_5$ | $C_2H_5$ | Green | + |
| H | 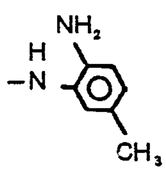 | $CH_3$ | H | $C_2H_5$ | $C_2H_5$ | Purple-Black | + |
| H | 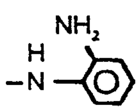 | H | H | $C_2H_5$ | $C_2H_5$ | Black | + |
| H | 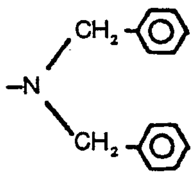 | H | H | $C_2H_5$ | $C_2H_5$ | Dark Green | + |
| H | 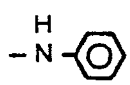 | H | H | $C_2H_5$ | $C_2H_5$ | Black | + |
| H | 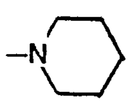 | H | H | $C_2H_5$ | $C_2H_5$ | Green | + |
| H | 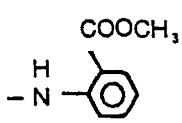 | H | H | $C_2H_5$ | $C_2H_5$ | Black | + |
| H | 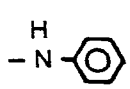 | $CH_3$ | H | $C_2H_5$ | $C_2H_5$ | Black | + |

| $R_a$ | $R_b$ | $R_c$ | $R_d$ | $R_e$ | $R_f$ | Developed Color | Phototropic Capacity |
|---|---|---|---|---|---|---|---|
| H | 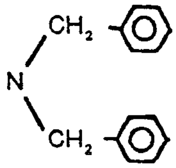 | H | H | 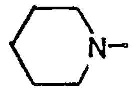 | | Green | + |
| H | $CH_3$ | H | $NH_2$ | $C_2H_5$ | $C_2H_5$ | Orange | + |
| H | $-NH_2$ | $CH_3$ | H | $C_2H_5$ | $C_2H_5$ | Purple | + |
| H | 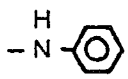 | $OCH_3$ | H | $C_2H_5$ | $C_2H_5$ | Black | + |
| H | Cl | $CH_3$ | H | $C_2H_5$ | $C_2H_5$ | Red | + |
| H | H | Cl | H | H | 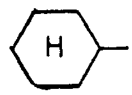 | Yellow-Orange | + |
| 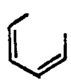 | | H | H | $C_2H_5$ | $C_2H_5$ | Pink | + |
| 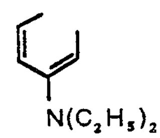 | | H | H | $C_2H_5$ | $C_2H_5$ | Blue | + |
| H | 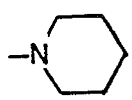 | H | H | | 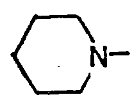 | Green | + |
| H | 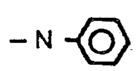 | H | H | 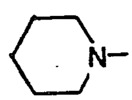 | | Black | + |
| H | $-S-CH_3$ | H | H | $C_2H_5$ | $C_2H_5$ | Red | + |

Dye base, color and phototropic capacity are indicated below:

| | | | |
|---|---|---|---|
| Rhodamine B Base | red | + | + |
| Malachite Green Base | blue-green | + | + |
| C.I. Solvent Blue 2 | red-blue | + | + |
| C.I. Solvent Blue 5 | red-blue | + | + |
| C.I. Solvent Red 49 | red-violet | + | + |
| C.I. Solvent Violet 10 | red-violet | + | + |
| C.I. 42510B | red-violet | + | + |
| C.I. 42535B | blue-violet | + | + |
| C.I. 42600 | blue-violet | + | + |
| C.I. 44520 | violet | + | + |
| C.I. 45006 | red | + | + |
| C.I. 45015 | red | + | + |
| C.I. 46025 | yellow | + | + |
| C.I. 46055 | orange | + | + |
| C.I. 48013 | red-violet | + | + |

Example 2

A photoresist composition useful to evaluate various combinations of colorformers and carbonylic halides is prepared from the following ingredients:

| | Parts by wt. |
|---|---|
| poly(methyl methacrylate)[(1)] | 60.0 |
| pentaerythritol triacrylate | 32.0 |
| benzophenone | 3.2 |
| 2,2'-methylene-bis-(4-ethyl-6-t-butylphenol) | .9 |
| Colorformer | .9 |
| Carbonylic halide | 2.2 |
| 4,4'-bis(dimethylamino)benzophenone | .8 |
| methyl ethyl ketone | 150.0 |

(1) a medium molecular weight product available from E. I. duPont de Nemours & Co., Inc., Wilmington, Delaware under the trademark Elvacite 2010.

The composition is made by dissolving the methyl methacrylate polymer in the solvent, using conventional equipment at low to medium speeds, then adding the monomer and then adding the remaining ingredients.

The solution is coated onto a 1 mil thick polyester film and dried in air. The dry thickness of the sensitized layer is 1—2 mils. The dried layer is covered with a 1 mil thick polyethylene film.

The following table indicates the phototropic capacity of six representative colorformers in the presence of a variety of carbonylic halides; phototropic capacity is determined as described in Example 1.

A = 2-anilino-3-methoxy-6-diethylaminofluoran
B = 2-anilino-6-diethylaminofluoran
C = 2-piperidino-6-diethylaminofluoran
D = 2-(N,N-dibenzylamino)-6-pyrrolidinofluoran
E = Rhodamine B Base
F = Malachite Green Base

| Halogenated Compound | A | B | C | D | E | F |
|---|---|---|---|---|---|---|
| hexabromoacetone | + | + | + | + | + | + |
| 3,4-diiodo-2-butanone | + | + | + | + | + | + |
| 3,3-dibromo-2-butanone | + | + | + | + | + | + |
| 3,3-dibromo-2-heptanone | + | + | + | + | + | + |
| 1,1-dibromo-4-ethoxy-2,4-butanedione | + | + | + | + | + | + |
| 1,4-diiodo-2,3-butanedione | + | + | + | + | + | + |
| 4,4-dibromo-2,3-hexanedione | + | + | + | + | + | + |
| 3,3-dibromo-2,4-hexanedione | + | + | + | + | + | + |
| perchloro-2-cyclobuten-1-one | + | + | + | + | + | + |
| 2,2,6,6-tetrabromocyclohexanone | + | + | + | + | + | + |
| 3,6-diiodo-1,2-cyclohexanedione | + | + | + | + | + | + |
| hexachloro-2,4-cyclohexanedione | + | + | + | + | + | + |
| 2-iodo-1,3-cyclohexanedione | + | + | + | + | + | + |
| 2,2-dibromo-5,5-dimethyl-1,3-cyclohexanedione | + | + | + | + | + | + |
| dibromomalonamide | + | + | + | + | + | + |
| iodomalonamide | + | + | + | + | + | + |
| dimethyl dibromomalonate | + | + | + | + | + | + |
| diethyl iodomalonate | + | + | + | + | + | + |
| 3-iodo-2-ketoglutaramide | + | + | + | + | + | + |
| dimethyl 3-iodo-4-ketopimaleate | + | + | + | + | + | + |
| diethyl-1,3-diiodo-1,3-acetone-dicarboxylate | + | + | + | + | + | + |
| diethyl-3,6-diiodo-1,4-cyclohexanedione-2,5-dicarboxylate | + | + | + | + | + | + |

Example 3

When the procedure of Example 2 is repeated using colorformers, A, B, C, D, E and F and dimethyl dibromomalonate, dibromomalonamide, diethyl-1,3-dibromo-1,3-acetone dicarboxylate and tetrabromocyclohexanone as the carbonylic halide with a variety of amines as hydrogen donors, the systems display phototropic capacity:

| Carbonylic Halide | I | | | | | | II | | | | | | III | | | | | | IV | | | | | |
|---|---|---|---|---|---|---|---|---|---|---|---|---|---|---|---|---|---|---|---|---|---|---|---|---|
| Colorformer | A | B | C | D | E | F | A | B | C | D | E | F | A | B | C | D | E | F | A | B | C | D | E | F |
| propylamine | + | + | + | + | + | + | + | + | + | + | + | + | + | + | + | + | + | + | + | + | + | + | + | + |
| diisopropanolamine | + | + | + | + | + | + | + | + | + | + | + | + | + | + | + | + | + | + | + | + | + | + | + | + |
| triethylamine | + | + | + | + | + | + | + | + | + | + | + | + | + | + | + | + | + | + | + | + | + | + | + | + |
| dimethylethanolamine | + | + | + | + | + | + | + | + | + | + | + | + | + | + | + | + | + | + | + | + | + | + | + | + |
| N,N-dimethyl butylamine | + | + | + | + | + | + | + | + | + | + | + | + | + | + | + | + | + | + | + | + | + | + | + | + |
| p-acetylphenyl dimethylamine | + | + | + | + | + | + | + | + | + | + | + | + | + | + | + | + | + | + | + | + | + | + | + | + |
| p-caprylphenyl dimethylamine | + | + | + | + | + | + | + | + | + | + | + | + | + | + | + | + | + | + | + | + | + | + | + | + |
| p-dimethylaminophenyl acetate | + | + | + | + | + | + | + | + | + | + | + | + | + | + | + | + | + | + | + | + | + | + | + | + |
| p-dimethylaminophenyl valerate | + | + | + | + | + | + | + | + | + | + | + | + | + | + | + | + | + | + | + | + | + | + | + | + |
| ethyl dimethylaminobenzoate | + | + | + | + | + | + | + | + | + | + | + | + | + | + | + | + | + | + | + | + | + | + | + | + |
| amyl dimethylaminobenzoate | + | + | + | + | + | + | + | + | + | + | + | + | + | + | + | + | + | + | + | + | + | + | + | + |
| p-dimethylamino acetophenone | + | + | + | + | + | + | + | + | + | + | + | + | + | + | + | + | + | + | + | + | + | + | + | + |
| 4-dimethylamino benzophenone | + | + | + | + | + | + | + | + | + | + | + | + | + | + | + | + | + | + | + | + | + | + | + | + |
| 4,4'-bis-(dimethylamino)-benzophenone | + | + | + | + | + | + | + | + | + | + | + | + | + | + | + | + | + | + | + | + | + | + | + | + |

I = dimethyl dibromomalonate
II = dibromomalonamide
III = diethyl-1-3-dibromo-1,3-acetonedicarboxylate
IV = tetrabromocyclohexanone

Example 4

Combinations of photoinitiators and amines can be evaluated using the following composition and the procedures described in Examples 2 and 3.

| | Parts by wt. |
|---|---|
| poly (methyl methacrylate)[(1)] | 60.0 |
| pentaerythritol triacylate | 30.0 |
| photoinitiator | 3.2 |
| 2,2'-methylene-bis-(4-ethyl-6-t-butylphenol) | .9 |
| colorformer | .9 |
| 2,2,6,6-tetrabromocyclohexanone | 2.2 |
| amine | 2.8 |
| methyl ethyl ketone | 150.0 |

(1) Elvacite 2010 from Du Pont.

The following table indicates phototropic capacity of representative colorformers A and B of Example 2 with a variety of photoinitiators and amines.

*Photoinitiator*

1. thioxanthone
2. 2-chlorothioxanthone
3. fluorenone
4. benzil

| *Photoinitiator* | 1 | | 2 | | 3 | | 4 | |
|---|---|---|---|---|---|---|---|---|
| *Colorformer* | A | B | A | B | A | B | A | B |
| dimethylethanolamine | + | + | + | + | + | + | + | + |
| N,N-dimethyl butylamine | + | + | + | + | + | + | + | + |
| p-acetylphenyl dimethylamine | + | + | + | + | + | + | + | + |
| p-caprylylphenyl dimethylamine | + | + | + | + | + | + | + | + |
| p--dimethylaminophenyl acetate | + | + | + | + | + | + | + | + |
| p-dimethylaminophenyl valerate | + | + | + | + | + | + | + | + |
| ethyl dimethylamino benzoate | + | + | + | + | + | + | + | + |
| amyl dimethylamino benzoate | + | + | + | + | + | + | + | + |
| p-dimethylamino acetophenone | + | + | + | + | + | + | + | + |
| 4-dimethylamino benzophenone | + | + | + | + | + | + | + | + |
| 4,4'-bis (dimethylamino)benzophenone | + | + | + | + | + | + | + | + |

Example 5

The following solution is coated onto a 1 mil thick polyester film to provide a dry thickness of about 0.001 inch, and dried in air. The dried film is covered with a 1 mil thick polyethylene film.

| Ingredients | Parts by wt. |
|---|---|
| copolymer of 75% styrene and 25% methacrylic acid; viscosity of a 40% solution in MEK is 10,360 cps | 57.0 |
| trimethylolpropane triacrylate | 24.0 |
| tetraethylenglycol diacrylate | 12.2 |
| benzophenone | 4.0 |
| 4,4'-bis-(dimethyamino)-benzophenone | 0.6 |
| 2-anilino-3-methoxy-6-diethylaminofluoran | 0.3 |
| diethyliodomalonate | 1.5 |
| benzotriazole | .4 |
| methyl ethyl ketone | 160.0 |

A piece of copper clad, epoxy-fibreglass board is cleaned by scouring with an abrasive cleaner, swabbing and thoroughly rinsing in water. It is given a 20 second dip in dilute hydrochloric acid solution (2 volumes water plus 1 volume concentrate hydrochloric acid), a second rinse with water and then dried with air jets.

The polyethylene cover film is removed from a section of the sandwiched photoresist dry film described above. The bared resist coating with its polyester support is laminated to the clean copper with the surface of the photoresist in contact with the copper surface. The lamination is carried out with the aid of rubber covered rollers operating at 250°F (121°C) with a pressure of 3 pounds per lineal inch at the nip at a rate of 2 feet per minute. The resulting sensitized copper clad board protected as it is by the polyester film can be held for later use if desired. Exposure to light is had through a high contrast transparency image in which the conducting pattern appears as transparent areas on an opaque background.

Exposure is carried out by placing the sensitized copper clad board (with polyester film still intact) and the transparency into a photographic printing frame. Exposure is maintained for a period of 90 seconds to a 400 watt, 50 ampere vapor lamp at a distance of 12 inches. It is seen that the areas of the resist that have been exposed to light have darkened in color considerably, to a black color which contrasts substantially with the unexposed portions of the resist. The polyethylene terephthalate support film is peeled off the exposed resist layer developed by agitating the board in a tray containing 2% trisodium phosphate in water for 2 minutes followed by a water rinse. The resulting board which contained a deeply colored resist pattern of the clear areas of the exposing transparency is then etched in ferric chloride solution, rinsed and dried. The resist is removed from the remaining copper by dipping for 2 minutes in a 3% solution of sodium hydroxide in water at 70°C. The result is a high quality printed circuit board.

In an alternative embodiment, the surface of the exposed copper obtained after developing is further cleaned by dipping the board into a 20% ammonium persulfate bath for 30 seconds, washing copiously with water, dipping for 30 seconds in a 20% solution of hydrochloric acid in water, rinsing with water, then drying the board with jets of air. This cleaned board is then plated for 45 minutes at 30 amperes per square foot in a copper pyrophosphate plating bath at 55°C.

Example 6

A copper clad piece of epoxy-fibreglass board is cleaned as described in Example 5 above. The cleaned, dried board was sensitized by flowing the following solution over the surface of the board.

| Ingredients | Parts by wt. |
|---|---|
| Copolymer of 37% styrene and 63% monobutyl maleate, average mol. wt. 20,000, viscosity of 10% aqueous solution of ammonium salt = 150 cps. | 60.0 |
| Pentaerythritol tetraacrylate | 34.2 |
| Benzophenone | 2.5 |
| 4,4'-bis-(dimethylamino)-benzophenone | 0.3 |
| Benzotriazole | 0.2 |
| 2,2'-methylene-bis-(4-ethyl-6-tert-butylphenol) | 0.9 |
| 2-anilino-3-methoxy-6-diethylaminofluoran | 0.4 |
| 2,2,6,6-tetrabromocyclohexanone | 1.5 |
| Methyl Ethyl Ketone | 150.0 |

The excess solution is drained off the board at room temperature for 2 minutes. The coating is further dried by heating in a forced air oven at 60°C for 5 minutes.

After cooling, the coated board is exposed as described in Example 5 above, and it is seen that where the board is exposed to light, a dark color that dramatically contrasts with the unexposed portions is visible. The resist is developed by agitating the board in a solution of 2% trisodium phosphate in water for one minute, followed by a water rinse. The board is etched in ferric chloride as described in Example 5, and after etching, the exposed resist is stripped from the protected copper by immersing the board in a 3% solution of sodium hydroxide in water at 50°C. for 2 minutes. The result is a high quality printed circuit board.

Example 7

Coating compositions are prepared from the following amounts of components:

| Components | Composition, Parts by Wt. | | | | |
|---|---|---|---|---|---|
| | I | II | III | IV | V |
| PCP[a] | 36.2 | — | — | — | — |
| EPOA[b] | 4.8 | 4.5 | — | — | — |
| E.D.[c] | 16.2 | 57.0 | 54.5 | 59.5 | 47.6 |
| NPGDA[d] | 14.2 | 18.1 | 17.3 | 19.0 | 19.0 |
| EHA[e] | 14.2 | 9.0 | 8.7 | 9.5 | 9.5 |
| DCPA[f] | 9.6 | 6.9 | 15.2 | 7.2 | 19.0 |
| Benzophenone | 4.8 | 4.5 | 4.3 | 4.8 | 4.9 |
| Colorformer[g] | 0.9 | 0.9 | 0.9 | 0.9[h] | 0.9[i] |
| Dibromomalonamide | 1.5 | 1.5 | 1.5 | 1.5 | 1.5 |
| 4,4′-bis(dimethylamino) benzophenone | .5 | .5 | .5 | .5 | .5 |

(a) 80% solution of Union Carbide PCP-0300 polycaprolactone/toluene diisocyanate oligomer in 20% hydroxyethyl acrylate
(b) polyacrylate of epoxidized soya bean oil available from Union Carbide
(c) Epocryl (epoxy diacrylate)
(d) neopentyl glycol diacrylate
(e) 2-ethylhexyl acrylate
(f) dicyclopentyl acrylate
(g) 2-anilino-3-methoxy-6-diethylaminofluoran
(h) 2-anilino-6-diethylaminofluoran
(i) 2-piperidino-6-diethylaminofluoran

The compositions are prepared by combining the monomers and mixing in conventional equipment at low to medium speeds until dissolved. The photoinitiator is added and the other ingredients are incorporated.

The coatings are applied to a cellulosic substrate (hardboard) by direct roller coating. The wet coated substrate is then exposed to UV radiation by being placed on a chain link conveyor and passed under a 200 watt/lineal inch Hanovia quartz ultraviolet lamp at a distance of about two inches at a speed of approximately 12 feet per minute.

Tough, resistant, deeply colored coatings are obtained.

Example 8

An ink composition is prepared as follows by mixing together the following components in conventional manner.

| | |
|---|---|
| Epoxy Acrylate | 60.0 |
| Ultraflex Microcrystalline Wax | 3.3 |
| Pentaerythritol Tetraacrylate | 29.2 |
| Benzophenone | 4.5 |
| 4,4′-bis (dimethylamino)benzophenone | .50 |
| 2-anilino-3-methoxy-6-diethylaminofluoran | 1.0 |
| Dibromomalonamide | 1.50 |

When this ink is silk screened onto a paper substrate and exposed to light using a 200 watt/linear inch medium pressure mercury vapor lamp at a distance of 4 inches for about 5 seconds, there is obtained a dry, tack-free dark-printed substrate having good gloss and adhesion.

When the color former is replaced by the colorformers described in Example 1, there is obtained an ink that cures to a dry, tack-free, deeply colored product.

Example 9

An acrylated urethane modified polyester can be prepared as follows:

To a reaction vessel equipped with stirrer, reflux condenser, thermometer and heating means charge

| | Parts by Weight |
|---|---|
| 1,3-butylene glycol | 12.68 |
| 1,6-hexanediol | 66.64 |
| adipic acid | 20.58 |
| dibutyl Tin Oxide | .10 |

using a nitrogen sparge. Heat to a reflux and react to an acid value less than 3. The product will have an equivalent weight of about 501 and a molecular weight of about 1000.

To a reaction vessel equipped with a stirrer, thermometer and nitrogen sparge charge 15.22 parts by weight of 2,4-tolylene diisocyanate and heat to 50°C. Add a mixture of 10.13 parts by weight of 2-ethylhexyl acrylate and 0.0035 parts by weight of phenothiazine over a two hour period, maintaining the temperature at 60°C during this period. Hold at 60°C for an additional three hours. Cool to 50°C and add 43.83 parts by weight of the polyester previously prepared over a one hour period, maintaining the temperature at 60°C; thereafter hold the temperature at 70°C for 3 hours. Cool to 60°C; add 0.35 parts by weight of methanol to obtain zero free isocyanate and hold an additional 1/2 hour at 60°C. Cool and store the product.

A. A UV curable composition can be prepared having the following composition:

| | Parts by Weight |
|---|---|
| Acrylated polyester | 66.6 |
| 1,6-hexanediol diacrylate | 14.5 |
| Pentaerythritol triacrylate | 4.6 |
| Methyl ethyl ketone | 1.9 |
| 2-ethylhexyl acrylate | 4.7 |
| Dibromomalonamide | 2.0 |
| 2-Chlorothioxantheonone | 3.0 |
| 2-anilino-3-methoxy-6-diethylaminofluoran | .7 |
| dimethylamino ethanol | 2.0 |

The composition is mixed until homogeneous. The photopolymerizable composition is applied to a wooden test piece, having a smooth surface, at the rate of 100 grams per square meter and the coated surface is covered witha 30 mm. thick untreated polyethylene film exercising care to ensure that no air bubbles are entrained. This is then exposed to actinic rays with a 2-KW high pressure mercury-vapor lamp for 30 seconds at a radiation distance of 30 mm. When the polyethylene film is stripped, it is seen that a smooth cured coating is obtained having good hardness, good adhesion to the wood and that is black in color.

B. A second UV-curable system can be prepared having the following composition:

| | Parts by Weight |
|---|---|
| Acrylated polyester | 65.3 |
| Pentaerythritol tetrakis (β-mercaptopropionate) | 26.0 |
| Benzophenone | 3.0 |
| 2-anilino-3-methoxy-6-diethylaminofluoran | .7 |
| 4,4′-bis(dimethylamino)benzophenone | 3.0 |
| Dibromomalonamide | 2.0 |

When coated on a wood test specimen and treated as in Part A above, there is obtained a cured coating having a black color.

**Claims**

1. A phototropic photosensitive composition, such as a film, comprising (a) at least one component which is capable of curing, cross-linking or polymerising upon initiation, such as a compound containing an acrylyl or methacrylyl group or an epoxide-group containing compound, (b) at least one intiator for the component (a) which is potentiated by active radiation, (c) the free base of a dyestuff that forms a halide salt which is more intensely coloured than the free base and (d) a latent activator which releases free halogen radicals when exposed to actinic light and comprises a halogen-containing organic compound, said composition being characterised in that said latent activator comprises a proton donor together with a halogenated aliphatic ketone, a halogenated cycloaliphatic ketone, an ester of a halogenated aliphatic dicarboxylic acid or an amide of a halogenated aliphatic dicarboxylic acid.

2. A composition as claimed in claim 1 further characterised in that an ester or amide of a halogenated dicarboxylic acid having at least one halogen atom, preferably two such atoms, attached to a carbon atom which is alpha to a carbonyl group is used as said ester or amide.

3. A composition as claimed in claim 1 further characterised in that a halogenated aliphatic ketone is used having 3 to 13 carbon atoms and having the general formula

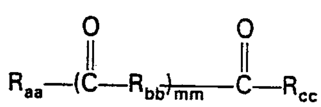

in which $R_{aa}$ is an alkyl group having 1 to 11 carbon atoms and may contain halogen atoms, $R_{bb}$ is an alkylene group having 1 to 10 carbon atoms and may contain halogen atoms or $R_{bb}$ represents a covalent bond, $R_{cc}$ is an alkyl or alkoxy group having 1 to 11 carbon atoms and may contain halogen atoms, and mm is 0, 1, 2 or 3, and at least one of $R_{aa}$, $R_{bb}$, $R_{cc}$ contains at least one halogen atom.

4. A composition as claimed in claim 1 further characterised in that said halogenated cycloaliphatic ketone has the general formula

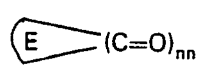

in which E is the halogenated residue of a carbocyclic ketone which, including the bound carbonyl group or groups contains from 4 to 8 carbon atoms in the ring and may be substituted, in addition to halogen, by lower alkyl or alkoxy or acyl having 2 to 6 carbon atoms and nn is 1 or 2.

5. A composition as claimed in either of claims 1 or 2 further characterised in that said ester or amide has the general formula

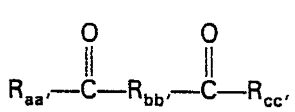

in which $R_{aa'}$ is an amino group which may be substituted by one or two lower alkyl or lower haloalkyl groups, or is an alkoxy or haloalkoxy group having 1 to 4 carbon atoms, or $R_{aa'}$ is the group

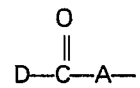

in which D is an alkoxy or haloalkoxy group having 1 to 4 carbon atoms and A is an alkylene or haloalkylene group having 1 to 4 carbon atoms, $R_{bb}$ is an alkylene or haloalkylene group having 1 to 4 carbon atoms or is a covalent bond or is the group

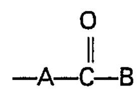

in which each of A and B is an alkylene or haloalkylene group having 1 to 4 carbon atoms, and $R_{cc'}$ is an amino group which may be substituted by one or two lower alkyl or lower haloalkyl groups or is an alkoxy or haloalkoxy group having 1 to 4 carbon atoms, at least one of $R_{aa'}$, $R_{bb'}$, and $R_{cc'}$ containing at least one halogen atom.

6. A composition as claimed in any of the preceding claims further characterised in that the free base of a dyestuff which forms a halide salt which is more intensely coloured than the free base is an amino-fluoran compound having the general formula

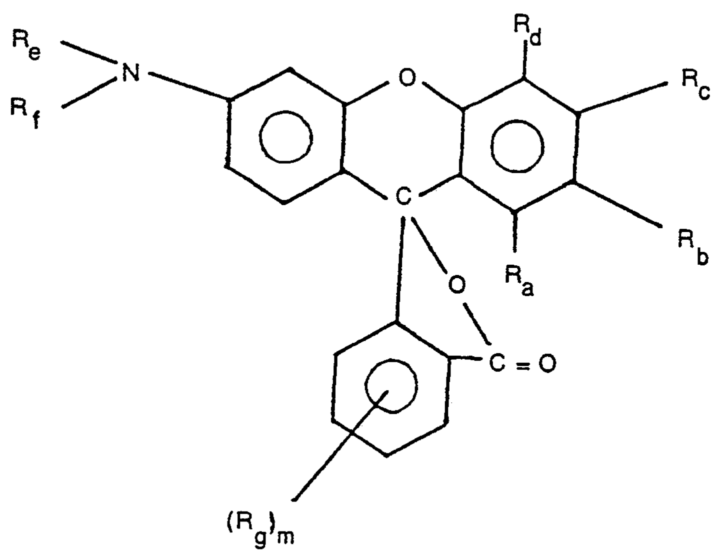

in which $R_a$ is a hydrogen or halogen atom or an aliphatic hydrocarbon or hydrocarbonoxy group having 1 to 12 carbon atoms which may be interrupted by —NH— or —O— and may be substituted; $R_b$ is a primary, secondary or teritary amino group in which the substituents on the nitrogen atom, when present, are aliphatic, cycloaliphatic, aromatic or araliphatic hydrocarbon groups which may be substituted or $R_b$ is a heterocyclic group having 3 to 12 ring atoms which is linked through a nitrogen atom and may, in addition, have oxygen and/or sulphur as ring atoms; or $R_a$ and $R_b$ may together form a condensed aromatic nucleus, $R_c$ is a hydrogen or halogen atom or an aliphatic hydrocarbon or hydrocarbonoxy group having 1 to 12 carbon atoms which may be interrupted by nitrogen or oxygen, or $R_c$ is a primary, secondary or tertiary amino group in which the substituent on the nitrogen atom, when present, are aliphatic, cycloaliphatic, aromatic or araliphatic hydrocarbon groups which may be substituted, or $R_c$ is a heterocyclic group having 3 to 12 ring atoms and may, in addition, have oxygen and/or sulphur as ring atoms, or $R_c$ is an aromatic hydrocarbon group which may be substituted, an araliphatic group or an aromatic ether or an aromatic aliphatic ether group, $R_d$ is a hydrogen atom, a lower aliphatic hydrocarbon or hydrocarbonoxy group or a primary, secondary or tertiary amino group in which the substituents on the nitrogen atom, when present, are aliphatic, cycloaliphatic, aromatic or araliphatic hydrocarbon groups which may be substituted or $R_d$ is a heterocyclic group having 3 to 12 ring atoms and containing one or more of nitrogen, oxygen and sulphur as ring atoms; each of $R_e$ and $R_f$ is a hydrogen atom or an aliphatic hydrocarbon group having 1 to 12 carbon atoms and may be substituted and may be interrupted by oxygen or nitrogen, a cycloaliphatic, aromatic or araliphatic hydrocarbon group or $R_e$ and $R_f$ together with the nitrogen atom to which they are attached form a heterocyclic ring having 3 to 12 ring atoms and may, in addition, have oxygen and/or

sulphur as ring atoms; each $(R_g)$ is a hydrogen or halogen atom, lower aliphatic hydrocarbon or hydrocarbonoxy group, or an acetamido or primary, secondary or tertiary amino group; m is an integer from 1 to 3 and at least one of $R_b$, $R_c$ and $R_d$ is an amino group.

7. A composition as claimed in any of the preceding claims further characterised in that the free base of said dyestuff has the general formula

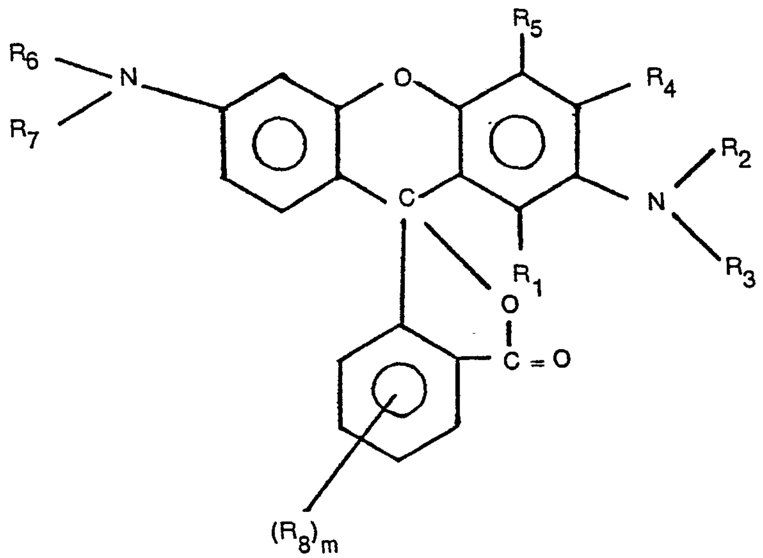

in which $R_1$ is a hydrogen or halogen atom or an alkyl or alkoxy group having 1 to 12 carbon atoms, each of $R_2$ and $R_3$ is a hydrogen atom, an alkyl group having 1 to 12 carbon atoms, an alkenyl group having 2 to 12 carbon atoms, an alkoxyalkyl group having 2 to 8 carbon atoms, an alkoxycarbonylalkyl group having 2 to 9 carbon atoms, a cycloalkyl group having 5 or 6 carbon atoms, an acyl group having 1 to 12 carbon atoms or a phenyl, naphthyl or benzyl group which may be substituted in one to three nuclear positions by any amino, mono- or dialkylamino groups having 1 to 5 carbon atoms, alkyl or alkoxy groups having 1 to 7 carbon atoms, carboxyl, alkoxycarbonyl groups having 2 to 7 carbon atoms, acyl or acylamino groups having 1 to 5 carbon atoms or $—MeSO_3$ wherein Me is an alkali metal, or $R_2$ and $R_3$ taken together with the nitrogen atom to which they are attached together form a pyrrolidinyl, piperidyl, pipecolinyl, perhydroazepinyl, heptamethyleneimino, octamethyleneimino, indolinyl, 1,2,3,4-tetrahydroquinolinyl, hexahydrocarbazolyl, morpholinyl, thiomorpholinyl, piperazinyl, an N-alkylpiperazinyl group having 1 to 4 carbon atoms in the alkyl group, a pyrazolinyl or 3-methylpyrazolinyl group, $R_4$ is a hydrogen or halogen atom, an alkyl or alkoxy group having 1 to 12 carbon atoms or is a group having the formula $—NR_2R_3$ in which $R_2$ and $R_3$ are as defined above or $R_4$ is a phenyl, phenoxy, benzyl or benzyloxy group which is either unsubstituted or which may be substituted in 1 to 3 nuclear positions by any of amino, mono- or dialkylamino having 1 to 5 carbon atoms, lower alkyl or alkoxy, carboxyl, alkoxycarbonyl having 2 to 7 carbon atoms, acyl having 1 to 5 carbon atoms on $MeSO_3—$ wherein Me is an alkali metal, $R_5$ is a hydrogen atom, a lower alkyl or alkoxy group or is a group having the formula $—NR_2R_3$ in which $R_2$ and $R_3$ are as defined above, each of $R_6$ and $R_7$ is a group having the formula $—NR_2R_3$ in which $R_2$ and $R_3$ are as defined above, each $R_8$ is a hydrogen or halogen atom, an alkyl or alkoxy group having 1 to 7 carbon atoms, acetamido, amino or mono- or di-alkylamino having 1 to 7 carbon atoms and *m* is as defined in claim 6.

8. A composition as claimed in any of the preceding claims characterized in that said poymerisable or crosslinkable component (a) is a mixture of a preformed crosslinkable polymer and a polymerisable monomer component.

9. A composition as claimed in claim 8 characterised in that it comprises

(i) 40—67.8% by weight of said preformed polymer,
(ii) 30—50% by weight of said polymerisable component,
(iii) 1—10% by weight of said initiator (b),
(iv) 0.01—2% by weight of the free base of the fluoran dyestuff defined in claim 6 or claim 7,
(v) 0.1—5% by weight of said halogenated aliphatic ketone, halogenated cycloaliphatic ketone or ester or amide of said halogenated aliphatic dicarboxylic acid.
(vi) 0.1—10% by weight of an amine which acts as said proton donor.

10. A composition as claimed in any of the preceding claims further characterised in that it is in the form of a thin film.

**Revendications**

1. Composition photosensible phototropique telle qu'une pellicule comprenant (a) au moins un corps pouvant, après initiation, être développé, lié par des liaisons transversales ou polymérisé tel qu'un corps contenant un groupe d'acrylyl ou de métacrylyl ou un corps contenant un groupe epoxyde, (b) au moins un initiateur pour le corps (a) qui peut être activé par un rayonnement actif, (c) une base libre d'un colorant qui forme un sel haloïde qui est d'une coloration plus intense que celle de ladite base libre et (d) un activateur latent qui dégage des radicaux libres d'halogène lorqu'il est exposé à une lumière actinique et comprend un corps organique contenant de l'halogène caractérisée en ce que ledit activateur latent (d) comprend un donneur de protons avec une cétone aliphatique halogénée, une cetone cycloaliphatique halogénée, un esther d'un acide d'anhydride carbonique aliphatique halogéné ou un amide d'un acid anhydride carbonique aliphatique halogéné.

2. Composition selon la revendication 1 caractérisée en ce que ledit esther ou ledit amide de l'acide d'anhydride carbonique halogéné comprend au moins un atome d'halogène et de préférence deux atomes liés à un atome de carbone qui constituent un corps alpha d'un groupe de carbonyle.

3. Composition selon la revendication 1 caractérisée en ce que ledit cétone aliphatique halogénée comprend de l'ordre de 3 à 13 atomes de carbone et présente la formule générale suivante:

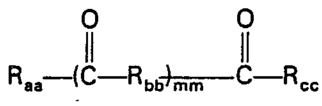

dans laquelle formule Raa est un groupe d'alcoyle comprenant de l'ordre de 1 à 11 atomes de carbone et éventuellement des atomes d'halogène Rbb est un groupe alcène comprenant de l'ordre de 1 à 10 atomes de carbone et éventuellement des atomes d'halogène ou qui est constitué par un lien d'une valence complémentaire, Rcc étant un groupe alcoyle ou alcoolate comprenant de 1 à 11 atomes de carbone et éventuellement des atomes d'halogène et mm étant égal à 0, 1, 2 ou 3, au moins l'un des corps Raa, Rbb, ou Rcc, contenant au moins un atome d'halogène.

4. Composition selon la revendication 1 caractérisée en ce que ledit cétone cycloaliphatique halogénée présente la formule générale suivante:

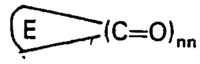

dans laquelle formule E est un résidu halogéné d'une cétone carboxyclique comprenant le ou les groupes liés par un carbonyle et qui contiennent dans un anneau de l'ordre de 4 à 8 atomes de carbone et peuvent être substitués en plus de l'halogène par un alcoyle ou alcoolate ou acyle d'un poids moléculaire moins important et contenant de l'ordre de 2 à 6 atomes de carbone, nn étant égal à 1 ou 2.

5. Composition selon l'une quelconque des revendications 1 ou 2 caractérisée en que ledit esther ou ledit amide présentent la formule générale suivante:

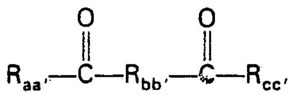

dans laquelle Raa' est un groupe d'amide qui peut être substitué par un ou deux groupes d'acoyle ou d'haloalcoyle d'un poids moléculaire plus faible, Raa' pouvant également être un groupe alcoolate ou haloalcoolate comprenant de l'ordre de 1 à 4 atomes de carbone ou encore par un groupe:

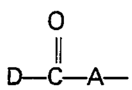

dans lequel D est un groupe d'alcoolate ou d'haloalcoolate comprenant de l'ordre de 1 à 4 atomes de carbone, A étant un groupe alcoylène ou haloalcoylène comprenant de l'ordre de 1 à 4 atomes de carbone, Rbb' étant un groupe alcoylène ou haloalcoylène comprenant de l'ordre de 1 à 4 atomes de carbone ou un corps de liaison de la même valence, ou encore un groupe:

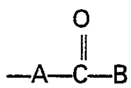

dans lequel A et B sont un groupe alcoylène ou haloalcoylène comprenant de l'ordre de 1 à 4 atomes de carbone, Rcc' étant un groupe d'amide qui peut être substitué par un ou deux groupes d'alcoyle ou d'haloalcoyle d'un poids moléculaire plus faible, Rcc' pouvent également être un groupe alcoolate ou haloalcoolate comprenant de l'ordre de 1 à 4 atomes de carbone, ou moins l'un des corps Raa', Rbb' et Rcc' contenant au moins un atome d'halogène.

6. Composition selon l'une quelconque des revendications 1 à 5 caractérisée en ce que ladite base libre du colorant qui forme un sel haloïde dont la coloration est plus intense que celle de la base libre est constitué d'un corps aminofluorane présentant la formule générale:

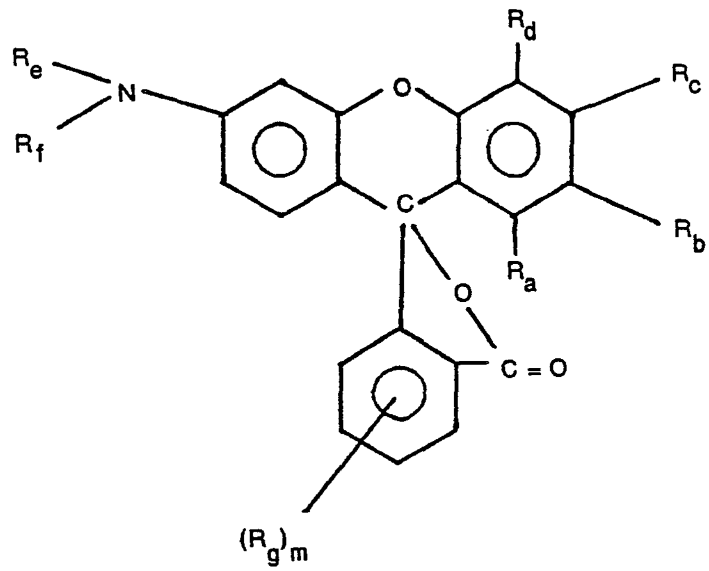

dans laquelle Ra est un atome d'hydrogène ou d'halogène ou un groupe d'hydrocarbone aliphatique ou un groupe d'oxyde d'hydrocarbure comprenant de l'ordre de 1 à 10 atomes de carbone qui peut être interrompu par un —NH— ou un —O— ou être substitué, Rb étant un groupe primaire, secondaire ou tertiaire d'amide dans lequel les substituant de l'atome d'azote sont, le cas échéant, des groupes aliphatiques, cycloaliphatiques aromatiques ou araliphatiques d'un hydrocarbure qui peut être substitué, Rb pouvant également être un groupe hétérocyclique comprenant dans un anneau de l'ordre de 3 à 12 atomes qui sont liés entre eux par un atome d'azote, Rb pouvant de plus comprendre en tant qu'atome d'anneau des atomes d'oxygène et/ou de soufre, Ra et Rb peuvent former ensemble un noyau aromatique condensé, Rc étant un atome d'hydrogène ou d'halogène ou un groupe d'hydrocarbure aliphatique ou un groupe d'oxyde d'hydrocarbure comprenant de l'ordre de 1 à 12 atomes de carbone et qui peut être interrompu par de l'azote ou de l'oxygène, Rc pouvant également être un groupe primaire, secondaire ou tertiaire d'amide dans lequel l'atome d'azote est le cas échéant substitué par des groupes aliphatiques, cycloaliphatiques aromatiques ou araliphatiques d'un hydrocarbure qui peuvent être substitutés, Rc pouvant également être un groupe hétérocyclique comprenant de l'ordre de 3 à 12 atomes dans un anneau qui peut de plus comprendre des atomes d'anneaux d'oxygène et/ou de soufre, Rc pouvant encore être un groupe aromatique d'hydrocarbure qui peut être substitué ou un groupe araliphatique ou encore un groupe d'éther aromatique ou un groupe d'éther aromatique aliphatique, Rd étant un atome d'azote, un groupe d'hydrocarbure aliphatique ou un groupe d'un oxyde d'hydrocarbure ou un groupe primaire, secondaire ou tertiaire d'amide dans lequel les substituants d'atome d'azote sont le cas échéant des groupes aliphatiques, cycloaliphatiques, aromatiques ou araliphatiques d'un hydrocarbure qui peuvent être substitués, Rd pouvant également être un groupe hétérocyclique comprenant de l'ordre de 3 à 12 atomes d'anneaux et contenant un ou plusieurs atomes d'anneaux d'azote, d'oxygène et de soufre, Re et Rf étant chacun constitué d'un atome d'hydrogène ou d'un groupe aliphatique d'hydrocarbure comprenant de l'ordre de 1 à 12 atomes de carbone et qui peut être substitué et être interrompu par un oxygène ou un azote ou encore par un groupe cycloaliphatique aromatique ou araliphatique d'un hydrocarbure, Re et Rf pouvant également former, avec l'atome d'azote auquel ils sont attachés, un anneau hétérocyclique comprenant de l'ordre de 3 à 12 atomes d'anneaux et pouvant comprendre de plus de l'oxygène et/ou du soufre sous forme d'atomes d'anneaux, chaque Rg étant constitué par un atome d'hydrogène d'halogène, par un groupe aliphatique d'hydrocarbure ou par un groupe d'un oxyde d'hydrocarbure ou encore par un groupe acétonique ou un groupe primaire, secondaire ou tertiaire d'amide, m étant un nombre entier compris entre 1 et 3 et au moins l'un des corps Rb, Rc et Rd étant un groupe d'amide.

7. Composition selon l'une quelconque des revendications 1 à 6 caractérisée en ce que la base libre dudit colorant présente la formule générale suivante:

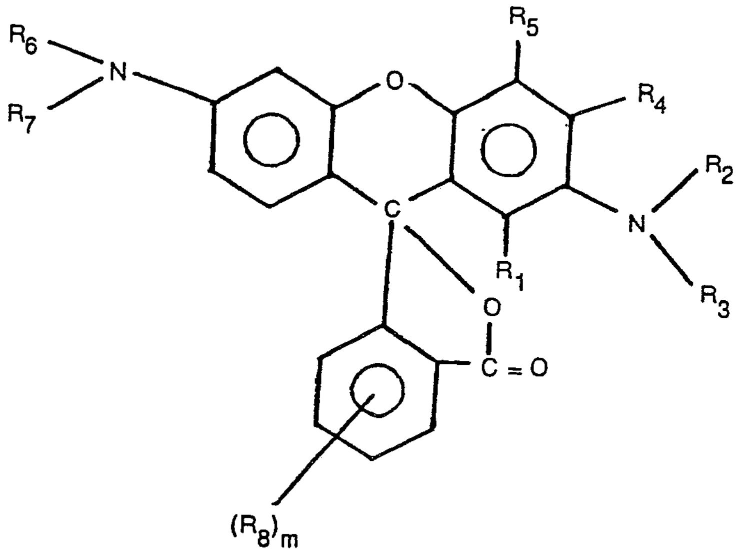

dans laquelle $R_2$ est un atome d'hydrogène ou d'halogène ou un groupe d'alcoyle ou d'alcoolate comprenant de l'ordre de 1 à 12 atomes de carbone, R2 et R3 étant chacun un atome d'hydrogène, un groupe alcoyle comprenant de l'ordre de 1 à 12 atomes de carbone, un groupe d'alkényle comprenant de l'ordre de 2 à 12 atomes de carbone, un groupe d'alcoyle d'alcoolate comprenant de l'ordre 2 à 8 atomes de carbone, un groupe d'alcoyle alcoolate de carbone comprenant de 2 à 9 atomes de carbone, un groupe cycloalcoyle comprenant de l'ordre de 5 à 6 atomes de carbone, un groupe acyle comprenant de l'ordre de 1 à 12 atomes de carbone ou encore un groupe de phényle, naphtyle ou benzyle qui peut-être substitué dans trois positions de noyau par un groupe d'amide ou un groupe de mono ou di-alcoyle d'amide comprenant de l'ordre de 1 à 5 atomes de carbone, par un groupe d'alcoyle ou d'alcoolate comprenant de l'ordre de 1 à 7 atomes de carbone, par des groupes de carboxyle, d'alcoolate carbonylé comprenant de l'ordre de 2 à 7 atomes de carbone, par des groupes d'acyle ou d'acyle d'amide comprenant de l'ordre de 1 à 5 atomes de carbone, ou encore par $MeSO_3$ dans lequel Me est un métal alcaloïde, R2 et R3 pouvant former avec l'atome d'azote qui les relie un groupe de pyrrolidinyle, de pipéridyle, de pipécolinyle, de périhydroazépinyle, d'heptaméthylénéine, d'octaméthylénéimine, d'indolinyl, 1,2,3,4-tétra-hydroquinolinyle, d'hexahydrocarbazolyle, de morpholinyle, de thiomorpholinyle, de pipérazinyle, de N-alcoylopiperazinyle comprenant de l'ordre de 1 à 4 atomes de carbone dans le groupe d'acoyle ou un groupe de pyrazolinyle ou de 3-méthyl-pyrazolinyle, R4 étant un atome d'hydrogène ou d'halogène, un groupe d'alcoyle ou d'alcoolate comprenant de l'ordre de 1 à 12 atomes de carbone ou encore un groupe présentant la formule $NR_2R_3$ dont des composants R2 et R3 sont déjà définis ci-dessus, R4 pouvant également être un groupe de phényle, de phénoxy, de benzyle, de benzyloxy qui est soit non substitué, soit substitué dans une ou trois positions de noyau par un amide ou un mono ou di-alcoyle d'amide comprenant de l'ordre de 1 à 5 atomes de carbone, par un alcoyle d'un plus faible poids moléculaire ou par un alcoolate, un carboxyle, un alcoolate carbonyle comprenant de l'ordre de 2 à 7 atomes de carbone ou encore par un acyle comprenant de l'ordre de 1 à 5 atomes de carbone sur $MeSO_3$ dont Me un métal alcaloïde, R5 étant un atome d'hydrogène un groupe inférieur d'alcoyle ou d'alcoolate ou encore un groupe présentant la formule $NR_2R_3$ dans laquelle R2 et R3 sont constitués par des corps tels que définis ci-dessus, R6 et R7 étant chacun formés par un groupe de la formule $NR_2R_3$ dans laquelle R2 et R3 sont des corps tels que définis ci-dessus, chaque corps R8 est constitué d'un atome d'hydrogène ou d'halogène, d'un groupe d'alcoyle ou d'alcoolate comprenant de l'ordre de 1 à 7 atomes de carbone ou encore d'un groupe d'acétamide, d'amide ou de mono ou di-alcoyle d'amide comprenant de l'ordre de 1 à 7 atomes de carbone, *m* étant formé par un corps tel que défini dans la revendication 6.

8. Composition selon l'une quelconque des revendications 1 à 7 caractérisée en ce que ledit corps polymérisable ou pouvant réaliser des liaisons transversales (a) est constitué par un mélange d'un polymère préformé à liaisons transversales et par un corps monomère polymérisable.

9. Composition selon la revendication 8 caractérisée en ce qu'elle est de la composition suivante:

(i) 40 à 67% en poids dudit polymère préformé,
(ii) 30 à 50% en poids dudit corps polymérisable,
(iii) 1 à 10% en poids dudit initiateur (b),
(iv) 0,01 à 2% en poids de la base libre du colorant de fluor tel que défini dans la revendication 6 ou la revendication 7,
(v) 0,1 à 5% en poids de ladite cétone aliphatique halogénée, de la cétone cycloaliphatique halogénée ou de l'esther ou de l'amide dudit acide dicarboxylique aliphatique halogéné,
(vi) 0,1 à 10% en poids d'un amide qui sert de donneur de protons.

10. Composition selon l'une quelconque des revendications précédentes caractérisée en ce qu'elle présente sous forme d'un film d'une faible épaisseur.

**Patentansprüche**

1. Phototropes, lichtempfindliches Material, wie etwa ein Film, mit (a) wenigstens einer, auf eine Reaktionseinleitung hin härtbaren, vernetzbaren oder polymerisierbaren Komponente, wie etwa eine Acrylyl- oder Methacrylyl-Gruppen aufweisende Verbindung, (b) wenigstens einem Initiator für die Komponente (a), der mittels aktiver Strahlung aktivierbar ist, (c) der freien Base einer Farbstoffverbindung, welche ein stärker als die freie Base gefärbtes Halogenidsalz bildet, und mit (d) einem latenten Aktivator, der eine organische, halogenhaltige Verbindung aufweist und bei Einwirkung aktinischer Strahlung freie Halogenradile freisetzt, dadurch gekennzeichnet, daß der latente Aktivator (d) einen Protonendonator aufweist, zusammen mit einem halogenierten aliphatischen Keton, einem halogenierten cycloaliphatischen Keton, einem Ester einer halogenierten, aliphatischen Di-Carbonsäure oder mit einem Amid einer halogenierten, aliphatischen Di-Carbonsäure.

2. Material nach Anspruch 1, dadurch gekennzeichnet, daß der Ester oder das Amid der halogenierten Di-Carbonsäure wenigstens ein Halogenatom aufweist, vorzugsweie zwei solche Halogenatome, welche(s) mit dem zur Carbonylgruppe alpha-ständigen Kohlenstoffatom verknüpft sind.

3. Material nach Anspruch 1, dadurch gekennzeichnet, daß das halogenierte aliphatische Keton 3 bis 13 Kohlenstoffatome aufweist und der nachstehenden allgemeinen Strukturformel entspricht

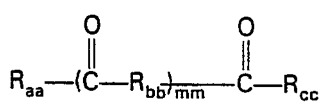

worin bedeuten: $R_{aa}$ einen $C_{1-11}$-Alkyl-Rest, der gegebenenfalls Halogenatome enthält; $R_{bb}$ eine $C_{1-10}$-Alkylengruppe, die gegebenenfalls Halogenatome enthält; oder $R_{bb}$ steht für eine kovalente Bindung; $R_{cc}$ ein $C_{1-11}$-Alkyl- oder Alkoxy-Rest, der gegebenenfalls Halogenatome enthält; mm eine der ganzen Zahlen 0, 1, 2 oder 3; wobei zumindest einer der Substituenten $R_{aa}$, $R_{bb}$ und $R_{cc}$ wenigstens ein Halogenatom enthält.

4. Material nach Anspruch 1, dadurch gekennzeichnet, daß das halogenierte cycloaliphatische Keton der nachstehenden allgemeinen Strukturformel entspricht

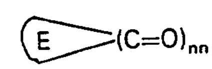

worin bedeuten: E der halogenierte Rest eines carbocyclischen Ketons, das einschließlich der gebundenen Carbonylgruppe(n) 4 bis 8 Kohlenstoffatome im Ring enthält und gegebenenfalls zusäzlich zu der halogensubstitution durch niedere $C_{2-6}$-Alkyl- oder Alkoxy- oder Acyl-Reste substituiert sein kann; und nn eine der ganzen Zahlen 1 oder 2.

5. Material nach einem der Ansprüche 1 oder 2, dadurch gekennzeichnet, daß der Ester oder das Amid der nachstehenden allgemeinen Strukturformel entspricht

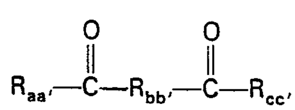

worin bedeuten: $R_{aa}$ eine Aminogruppe, die gegebenenfalls mit einer oder zwei niederen Alkylresten oder niederen Halogen-Alkylresten substituiert sein kann, oder ein $C_{1-4}$-Alkoxy- oder Halogenalkoxy Rest, oder $R_{aa}$, steht für eine Gruppe der nachstehenden Struktur

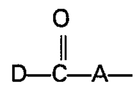

worin D für einen $C_{1-4}$-Alkoxy- oder Halogenalkoxy-Rest steht und A für eine $C_{1-4}$-Alkylen- oder Halogenalkylen-Gruppe steht; $R_{bb}$ eine $C_{1-4}$-Alkylen- oder Halogen-Alkylen-Gruppe oder eine kovalente Bindung oder eine Gruppe der nachstehenden Struktur

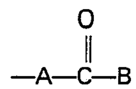

worin A und B jeweils stehen für eine $C_{1-4}$-Alkylen- oder Halogen-Alkylen-Gruppe; und $R_{cc}$, eine Aminogruppe die gegebenenfalls mit einem oder zwei niederen Alkyl- oder Halogen-Alkyl-Rest(en) substituiert sein kann oder ein $C_{1-4}$-Alkoxy- oder Halogen-Alkoxy-Rest; und wobei zumindest einer der Substituenten $R_{aa}$, $R_{bb}$, und $R_{cc}$, zumindest ein Halogenatom enthält.

6. Material nach einem der Ansprüche 1 bis 5, dadurch gekennzeichnet, daß die freie Base der Farbstoffverbindung, die ein stärker als die freie Base gefärbtes Halogenidsalz zu bilden vermag, eine Amino-Fluoran-Verbindung entsprechend der nachstehenden allgemeinen Strukturformel ist:

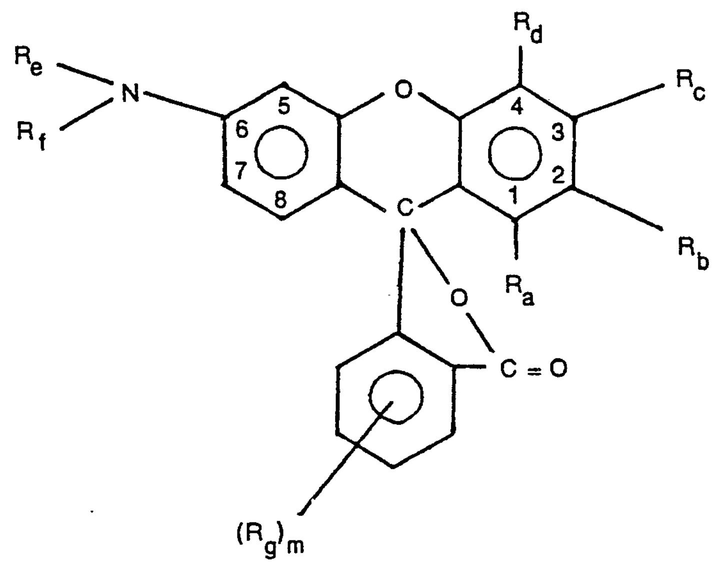

worin bedeuten: $R_a$ ein Wasserstoff- oder Halogenatom oder einen aliphatischen $C_{1-12}$-Kohlenwasserstoff- oder Oxy- Kohlenwasserstoff-Rest, der von —NH— oder —O— Gruppen unterbrochen sowie substituiert sein kann; $R_b$ eine primäre, sekundäre oder tertiäre Aminogruppe, deren Substituenten am Stickstoff (soweit vorhanden) aliphatische, cycloaliphatische, aromatische oder aromatisch-aliphatische Kohlenwasserstoffe sind, die ihrerseits substituiert sein können; oder $R_b$ steht für eine heterocyclische Gruppe mit 3 bis 12 über ein Stickstoffatom verknüpften Ringatomen, wobei zusätzlich Sauerstoff und/oder Schwefel als Ringatome auftreten können; oder $R_a$ und $R_b$ stehen zusammen für einen kondensierten aromatischen Kern; $R_c$ ein Wasserstoff- oder Halogenatom oder einen aliphatischen $C_{1-12}$-Kohlenwasserstoff- oder Oxy-Kohlenwasserstoff-Rest, der von Stickstoff oder Sauerstoff unterbrochen sein kann; oder $R_c$ steht für eine primäre, sekundäre oder tertiäre Aminogruppe, deren Substituenten am Stickstoff (soweit vorhanden) aliphatische, cycloaliphatische, aromatische oder aromatisch-aliphatische Kohlenwasserstoffe sind, die ihrerseits substituiert sein können; oder $R_c$ steht für eine heterocyclische Gruppe mit 3 bis 12 Ringatomen, wobei zusätzlich Sauerstoff und/oder Schwefel als Ringatome auftreten können; oder $R_c$ steht für einen aromatischen, gegebenenfalls substituierten Kohlenwasserstoffrest, für einen aromatisch-aliphatischen Rest oder für einen aromatischen Äther oder für einen aromatisch-aliphatischen Äther, $R_d$ ein Wasserstoffatom, einen niederen aliphatischen Kohlenwasserstoff oder Oxy-Kohlenwasserstoff-Rest oder eine primäre sekundäre oder tertiäre Aminogruppe, deren Substituenten am Stickstoff (soweit vorhanden) aliphatische, cycloaliphatische aromatische oder aromatisch-aliphatische Kohlenwasserstoffe sind, die ihrerseits substituiert sein können oder $R_d$ steht für eine heterocyclische

Gruppe mit 3 bis 12 Ringatomen einschließlich einem oder mehreren Stickstoff Sauerstoff und Schwefelatomen jeder der Substituenten $R_e$ und $R_f$ ein Wasserstoffatom oder einen aliphatischen $C_{1-12}$-Kohlenwasserstoff-Rest, der von Sauerstoff oder Stickstoff unterbrochen sowie substituiert sein kann, oder einen cycloaliphatischen, aromatischen oder aromatisch-aliphatischen Kohlenwasserstoff-Rest; oder $R_e$ und $R_f$ stehen zusammen mit dem Stickstoffatom, mit dem sie verknüpft sind, für einen heterocyclischen Ring mit 3 bis 12 Ringatomen, wobei zusätzlich Sauerstoff und/oder Schwefel als Ringatome auftreten können; jeder der Substituenten $R_g$ ein Wasserstoff- oder Halogenatom, einen niederen aliphatischen Kohlenwasserstoff oder Oxy-Kohlenwasserstoff-Rest oder einen Acetamido-Rest, oder eine primäre, sekundäre oder tertiäre Aminogruppe; m eine ganze Zahl von 1 bis 3, und wobei zumindest einer der Substituenten $R_b$, $R_c$ und $R_d$ für eine Aminogruppe steht.

7. Material nach einem der Ansprüche 1 bis 6, dadurch gekennzeichnet, daß die freie Base der Farbstoffverbindung der nachstehenden allgemeinen Strukturformel entspricht

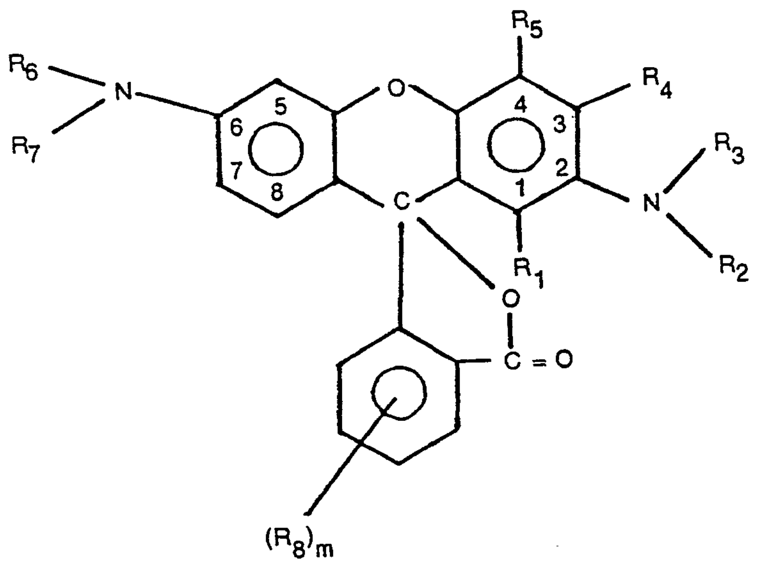

worin bedeuten: $R_1$ ein Wasserstoff- oder Halogenatom oder ein $C_{1-12}$-Alkyl- oder Alkoxy-Rest; jeder der Substituenten $R_2$ und $R_3$ ein Wasserstoffatom, ein $C_{1-12}$-Alkyl-Rest, eine $C_{2-12}$-Alkenylgruppe, ein $C_{2-8}$-Alkoxyalkyl-Rest, ein $C_{3-9}$-Alkoxycarbonyl-Alkyl-Rest, ein $C_{5\ oder\ 6}$-Cycloalkyl-Rest, ein $C_{1-12}$-Acyl-Rest oder eine Phenyl-, Naphthyl- oder Benzyl-Gruppe, welche ihrerseits in 1 bis 3 Kernpositionen substituiert sein können mit einer Aminogruppe oder einer Mono- oder Dialkylaminogruppe mit $C_{1-5}$-Alkyl-Resten, mit $C_{1-7}$-Alkyl- oder Alkoxy-Resten, mit $C_{2-7}$-Carboxyl- oder Alkoxycarbonyl-Resten, mit $C_{1-5}$-Acyl- oder Acylamino-Resten, oder mit einem —$MeSO_3$-Rest, wobei Me für ein Alkalimetall steht; oder $R_2$ und $R_3$ stehen zusammen mit dem Stickstoffatom, mit dem sie verknüpft sind, für einen Pyrrolidinyl-Rest, einen Piperidyl-Rest, einen Pipecolinyl-Rest, einen Perhydroazepinyl-Rest, einen Heptamethylenimino-Rest, einen Octamethylenimino-Rest, einen Indolinyl-Rest, einen 1,2,3,4-Tetrahydrochinolinyl-Rest, einen Hexahydrocarbazolyl-Rest, einen Morpholinyl-Rest, einen Thiomorpholinyl-Rest, einen Piperazinyl-Rest, einen N-Alkylpiperazinyl-Rest mit $C_{1-4}$-Alkyl-Gruppen, einen Pyrazolinyl- oder 3-Methylpyrazolinyl-Rest; $R_4$ ein Wasserstoff- oder Halogenatom, einen $C_{1-12}$-Alkyl- oder Alkoxy-Rest, oder einen Rest der Struktur —$NR_2R_3$, wobei $R_2$ und $R_3$ die oben angegebene Bedeutung haben; oder $R_4$ steht für eine Phenyl-, Phenoxy-, Benzyl- oder Benzyloxy-Gruppe, die entweder unsubstituiert ist, oder in 1 bis 3 Kernpositionen substituiert ist mit einer Aminogruppe, einer Mono- oder Dialkylamino-gruppe mit $C_{1-5}$-Alkyl-Resten, mit niederen Alkyl- oder Alkoxy-Resten, mit einem Carboxyl-Rest, mit $C_{2-7}$-Alkoxycarbonyl-Resten, mit $C_{1-5}$-Acylresten oder mit einer —$MeSO_3$-Gruppe, worin Me für ein Alkalimetall steht; $R_5$ ein Wasserstoffatom, einen niederen Alkyl- oder Alkoxy-Rest oder eine Gruppe der Struktur —$NR_2R_3$, worin $R_2$ und $R_3$ die oben angegebene Bedeutung haben; jeder der Substituenten $R_6$ und $R_7$ eine Gruppe der Struktur —$NR_2R_3$, worin $R_2$ und $R_3$ die oben angegebene Bedeutung haben; jeder der Substituenten $R_8$ ein Wasserstoff- oder Halogenatom, ein $C_{1-7}$-Alkyl- oder Alkoxy-Rest, ein Acetamido-Rest, eine Aminogruppe oder eine Mono- oder Dialkylaminogruppe mit $C_{1-7}$-Alkylresten; und m eine ganze Zahl von 1 bis 3.

8. Material nach einem der Ansprüche 1 bis 7, dadurch gekennzeichnet, daß die polymerisierbare oder vernetzbare Komponente (a) ein Gemisch aus einem vorgeformten, vernetzbaren Polymerisat und einer polymerisierbaren, monomeren Komponente ist.

9. Material nach Anspruch 8, gekennzeichnet durch die nachstehenden Anteile:

(u) 40 bis 67—80 Gew.-% vorgeformtes Polymerisat;
(v) 30 bis 50 Gew.-% polymerisierbare Komponente;
(w) 1 bis 10 Gew.-% Initiator (b);
(x) 0,01 bis 2 Gew.-% freie Base der Fluoran-Farbstoffverbindung entsprechend Anspruch 6 oder 7,
(y) 0,1 bis 5 Gew.-% halogeniertes aliphatisches Keton, halogeniertes cycloaliphatisches Keton oder der Ester oder das Amid der halogenierten, aliphatischen Di-Carbonsäure; und
(z) 0,1 bis 10 Gew.-% als Protonendonator wirkendes Amin.

10. Material nach einem der Ansprüche 1 bis 9, dadurch gekennzeichnet, daß das Material in Form einer Dünnschicht vorliegt.